(19)

Europäisches
Patentamt
European
Patent Office
Office européen
des brevets

(11) **EP 1 801 976 A1**

(12) **EUROPEAN PATENT APPLICATION**
published in accordance with Art. 158(3) EPC

(43) Date of publication:
**27.06.2007 Bulletin 2007/26**

(21) Application number: **05793159.4**

(22) Date of filing: **12.10.2005**

(51) Int Cl.:
*H03M 1/14* (2006.01)      *H03M 1/12* (2006.01)
*H03F 3/70* (2006.01)      *H03M 1/10* (2006.01)
*H03M 1/44* (2006.01)

(86) International application number:
**PCT/JP2005/018782**

(87) International publication number:
**WO 2006/041085 (20.04.2006 Gazette 2006/16)**

(84) Designated Contracting States:
**DE FR GB**

(30) Priority: **12.10.2004  JP 2004297963**
**20.10.2004  JP 2004305789**
**22.10.2004  JP 2004308034**

(71) Applicant: **SONY CORPORATION**
**Minato-ku**
**Tokyo (JP)**

(72) Inventors:
• **ONO, Koichi**
  **Shinagawa-ku, Tokyo 1410001; (JP)**
• **SEGAMI, Masahiro**
  **Shinagawa-ku, Tokyo 1410001; (JP)**

(74) Representative: **Robinson, Nigel Alexander Julian**
**D Young & Co**
**120 Holborn**
**London EC1N 2DY (GB)**

(54) **SAMPLE HOLD CIRCUIT, AND PIPELINE AD CONVERTER USING THE CIRCUIT**

(57)    A switched capacitor sample-and-hold circuit using a source grounded input operational amplifier, wherein a feed forward circuit or a feedback circuit is provided in the operational amplifier and connected to the feedback capacitor of the operational amplifier via switches, an input common voltage or a middle point voltage of outputs is detected, and a difference of the same from a reference voltage is previously charged in the feedback capacitor, thereby suppressing fluctuation of an output operation point at the time of amplification of the operational amplifier.

FIG. 7

**Description**

TECHNICAL FIELD

The present invention relates to a sample-and-hold circuit using switched capacitors and a pipeline AD converter using the same.

BACKGROUND ART

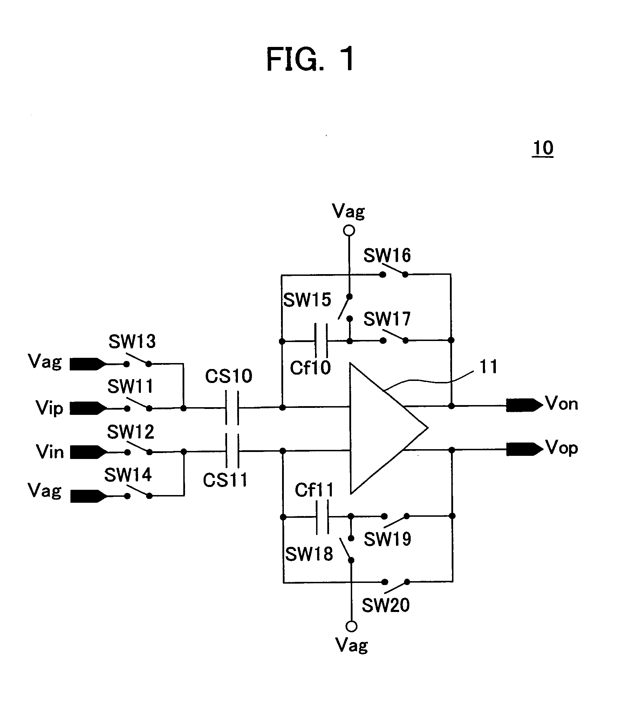

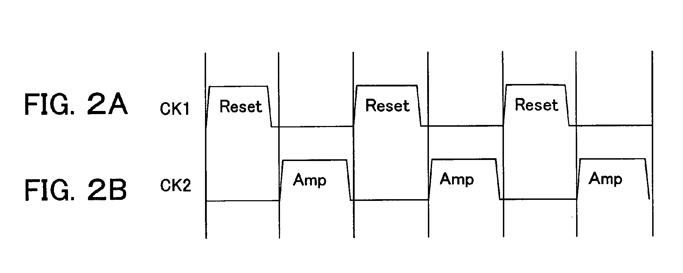

FIG. 1 shows a conventionally used basic S/H (sample-and-hold) circuit 10. The S/H circuit 10 is configured by an operational amplifier 11, switches SW11, SW12, SW13, SW14, SW15, SW16, SW17, SW18, SW19, and SW20, and switched capacitors comprised by capacitances CS10, CS11, Cf10, and Cf11.
Vag is connected via the switch SW13 to one side of the capacitor CS10, and Vip is connected via the SW11 to one side of the capacitor CS10. The other terminal is connected to the first input of the operational amplifier 11.
Further, Vin is connected via the SW12 to one side of the capacitor CS11, and Vag is connected via the SW14 to one side of the capacitor CS11. The other terminal is connected to the second input of the operational amplifier 11.
The first output of the operational amplifier 11 is connected via the SW16 to the first input, and a serially connected SW17 and capacitor Cf10 are connected in parallel to the first input and output.
The second output of the operational amplifier 11 is connected via the SW20 to the second input, and a serially connected SW19 and capacitor Cf11 are connected in parallel to the second input and output.
Here, SW11, SW12, SW15, SW16, SW18, and SW20 are controlled ON/OFF by a clock signal 1 (CK1), and SW13, SW14, SW17, and SW19 are controlled ON/OFF by a clock signal 2 (CK2).
The operation of the S/H circuit 10 will be explained by using the operation timing waveforms of FIG. 2. The switches are controlled ON/OFF by 2-phase nonoverlapping clock signals (CK1, CK2) shown in FIG. 2 and operate by 2 phases of a reset (sample) mode and an amplification (hold) mode.
As shown in FIG. 2A and FIG. 2B, in the reset mode, when the CK1 is set at an "H" level, the CK2 is set at an "L" level, the SW11, SW12, SW15, SW16, SW18, and SW20 become ON (short-circuited), and the SW13, SW14, SW17, and SW19 become OFF state (open).
As a result, the first input and output and the second input and output of the operational amplifier 11 are short-circuited, and the operational amplifier 11 is biased to an operation point having the highest gain (Vag).
Further, input voltages (Vip, Vin) are charged to a sampling capacitor CS for Vag. The amounts of charges charged in the sample capacitors CS (CS10, CS11) and the feedback capacitors Cf (Cf10, Cf11) (attention is paid to the change of only one side) become as in the following equations:

$$Qcs = CS \ (Vip-Vag)$$

$$(1)$$

$$Qcf = 0$$

$$(2)$$

On the other hand, in the amplification mode, in FIG. 2A and FIG. 2B, the CK1 becomes the "L" level, and the CK2 becomes the "H" level. As a result, the SW11, SW12, SW15, SW16, SW18, and SW20 are turned OFF, and the SW13, SW14, SW17, and SW19 are turned ON state (short-circuited). As a result, the operational amplifier 11 becomes a capacitive feedback type amplifier.
On the input side of the operational amplifier 11, the SW13 and SW14 are ON, the switch of the input is switched to Vag (terminal), and the amounts of charges charged in the sampling capacitors CS (CS10, CS11), and feedback capacitor Cf (Cf10, Cf11) become as in the following equations:

$$Qcs = 0$$

$$(3)$$

$$Qcf = Cf (Von-Vag)$$

$$(4)$$

The total charge amount is constant in the reset mode and the amplification mode, therefore the output voltage Von becomes:

$$Von = (CS/Cf)*(Vip-Vag) +Vag$$

$$(5)$$

and a difference of input voltage is multiplied by a capacitance ratio using Vag as reference and output.

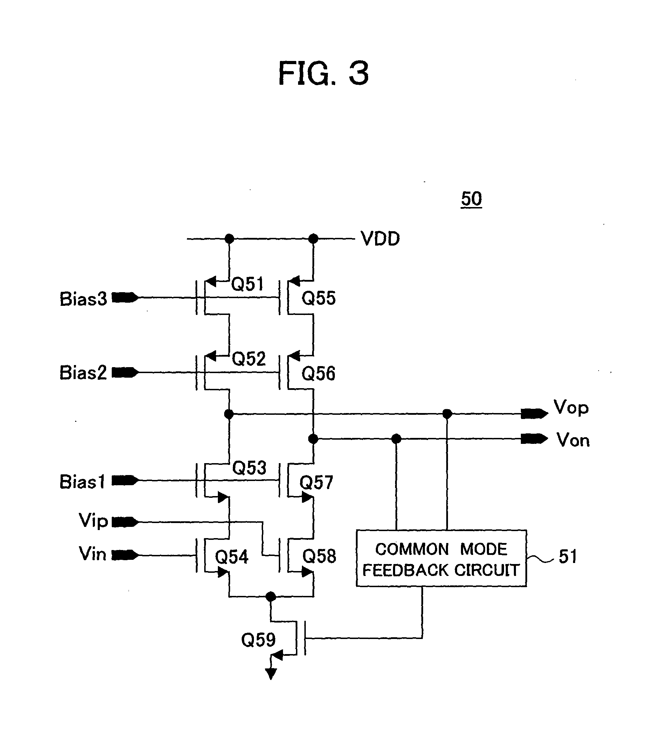

A source-coupled pair transistors input high gain operational amplifier as shown in FIG. 3 is used for such a switched capacitor type operational amplifier in many cases. Because it is a perfect differential type, the general practice is to detect a middle point voltage of the output signals and apply common mode feedback (CMFB) to obtain a desired output operation point Vag.
On the other hand, along with the recent reduction of voltages, it has been becoming very difficult to vertically stack a plurality of transistors as shown in FIG. 3.
As shown in FIG. 3, the source of a PMOS transistor Q51 is connected to a power supply VDD, and its drain is connected to a source of a PMOS transistor Q52. Further, a gate of the PMOS transistor Q51 is connected to a bias (Bias3). The drain of the PMOS transistor Q52 is connected to the drain of an NMOS transistor Q53, and its gate is connected to a bias (Bias2). The source of the NMOS transistor Q53 is connected to a drain of an NMOS transistor Q54, and its gate is connected to a bias (Bias1). The gate of the NMOS transistor Q54 is connected to Vin, its source is commonly connected to the source of an NMOS transistor Q58 and connected to the drain of an NMOS transistor Q59 constituting the current source, and the source of the NMOS transistor Q59 is connected to the ground.

The source of a PMOS transistor Q55 is connected to the power supply VDD, and its drain is connected to the source of the PMOS transistor Q56. Further, the gate of the PMOS transistor Q55 is connected to the bias (Bias3). The drain of the PMOS transistor Q56 is connected to the drain of an NMOS transistor Q57, and its gate is connected to the bias (Bias2). The source of the NMOS transistor Q57 is connected to the drain of the NMOS transistor Q58, and its gate is connected to the bias (Bias1). The gate of the NMOS transistor Q58 is connected to Vip, and its source is commonly connected to the source of the NMOS transistor Q54.

Drains of the NMOS transistor Q53 and the NMOS transistor Q57 are connected to a CMFB (common mode feedback) circuit 51 and are connected to outputs Vop and Von.
Further, the output of the CMFB circuit 51 is connected to the gate of the current source of the NMOS transistor Q59 and controls the current amount.

As explained above, the operational amplifier 50 having a input configuration with a source coupled pair transistors of the vertically stacked MOS transistors. It has the merit that the output resistance thereof can be made large, but intends to sacrifice the dynamic range of output of the operational amplifier 50. For this reason, there is a case where a folded configuration is employed, but this has the defect that the total current efficiency becomes small.

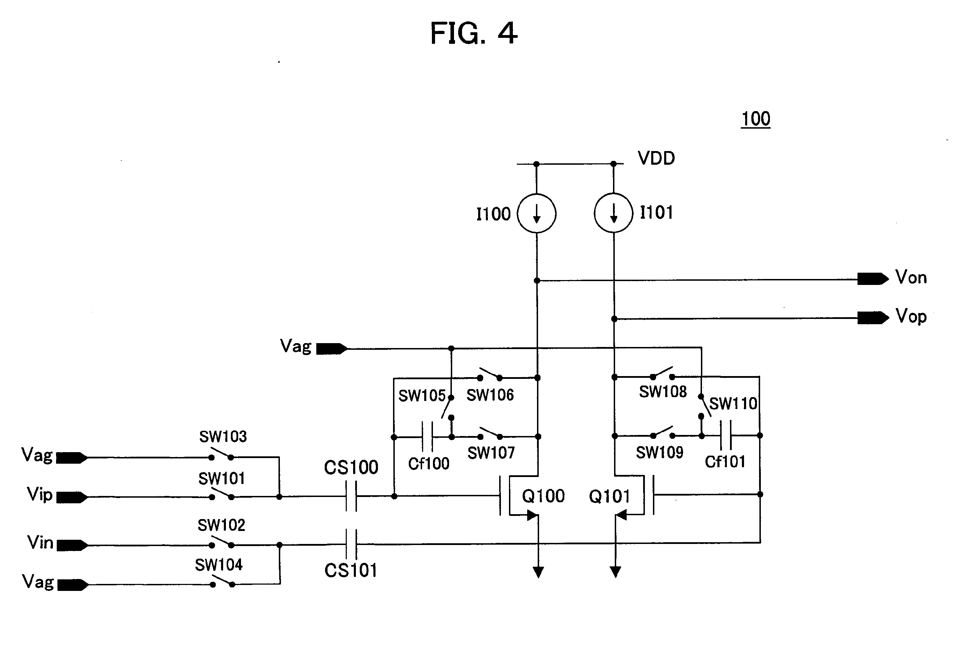

Contrary to this, an example of the circuit configuration of a sample-and-hold circuit 100 suitable for reduction the voltage by employing an operational amplifier having a source grounded type input stage is shown in FIG. 4.
One side of the current source I100 is connected to the voltage source VDD, and the other side is connected to the drain of the NMOS transistor Q100. The source of the NMOS transistor Q 100 is connected to the ground, an SW106 is connected between the gate and the drain, and in parallel to this a serially connected SW107 and capacitor Cf100 are connected. A common connection point of these capacitor Cf100 and SW107 is connected via an SW105 to Vag.
Further, one side of the current source I101 is connected to the voltage source VDD, and the other side is connected to the drain of the NMOS transistor Q101. The source of the NMOS transistor Q101 is connected to the ground, an SW108 is connected between the gate and the drain, and in parallel to this, a serially connected SW109 and capacitor Cf101 are connected. The common connection point of these capacitor Cf101 and SW109 is connected via an SW110 to Vag.

The gate of an NMOS transistor Q100 is connected to the capacitor CS100, further connected via the SW101 to Vip, and connected via the SW103 to Vag.

The gate of an NMOS transistor Q101 is connected to the capacitor CS101, further connected via an SW102 to Vin, and connected via an SW104 to Vag.

As explained above, using two source grounded amplifiers (Q100, Q101), they operate in a pseudo differential form. An input stage pair transistors are not biased at the current source, therefore one transistor greater dynamic range of output can be secured. Further, the output operation point is determined by the biasing by current sources (I100, I101) from a load side, therefore a CMFB circuit as in the conventional operational amplifier is not needed.

However, in the above operational amplifier using a source ground, the gm (trans-conductance) is determined by the frequency, therefore a further reduction of power consumption cannot be expected. Further, the electric characteristics of the operational amplifier with a source ground is changable against fluctuation of an input common voltage. Also, the amount of fluctuation of the common voltage is amplified in the same way as a differential signal component. For this reason, there is the defect that the operation at output point fluctuates from an original operation point, and the dynamic range of output is narrowed by this.

Patent Document 1: Japanese Patent Publication HEI No. 5-14199
Patent Document 2: Japanese Patent Publication No. 2000-201054
Non-Patent Document 1: Daisuke Miyazaki et al., "A 10-b 30-MS/s LOW-POWER Pipelined CMOS A/D Converter Using a Pseudo Differential Architecture", IEEE JOURNAL OF SOLID-STATE CIRCUIT, VOL. 38, No. 2, pp. 370-373, FEBRUARY 2003

DISCLOSURE OF THE INVENTION

PROBLEM TO BE SOLVED BY THE INVENTION

The present invention was made in consideration with the above problem and has desirable matters thereof to lower the power consumption of a source grounded operational amplifier and provide a sample-and-hold circuit employing an operational amplifier having a source grounded input transistors resistant to input common fluctuation and an AD converter using the same.

MEANS FOR SOLVING THE PROBLEM

The present invention has a first switch supplied with a first reference signal and operating ON/OFF by a first control signal; a second switch supplied with a first input signal and operating ON/OFF by a second control signal; a third switch supplied with a second reference signal and operating ON/OFF by said first control signal; a fourth switch supplied with a second input signal and operating ON/OFF by said second control signal; a first capacitor to which signals from said first and second switches are alternatively supplied in response to said first and second control signals; a second capacitor to which signals from said third and fourth switches are alternatively supplied in response to said first and second control signals; a first amplifier having outputs of said first and second capacitors connected to first and second input terminals, amplifying the same, and outputting the same from the first and second output terminals; a fifth switch and a third capacitor connected between said first input terminal and first output terminal; a sixth switch and a fourth capacitor connected between said second input terminal and second output terminal; first and second variable current sources connected between first and second output terminals of said first amplifier and a reference power supply; and an operation setting circuit supplied with said second control signal and fixing an operation state of said amplifier during the second control signal is supplied.

The present invention alternatively has first, second, third, fourth, fifth, and sixth switches controlled by first and second clocks equal in sampling frequency and not overlapping each other and becoming a conductive state at a point of time when said first clock is ON, seventh, eighth, ninth, and 10th switches which become the conductive state when said second clock is ON, an operational amplifier, a capacitor for applying a negative feedback to the operational amplifier, and a capacitor for sampling input signals via said third or fourth switch, wherein said first and second switches are connected in parallel to said capacitor for applying negative feedback to said operational amplifier, an input and output of said operational amplifier are short-circuited when said first clock is ON, a difference between a potential of a summing node and the input voltage is charged in the sample capacitor, a reference voltage for determining the operation point is supplied to said ninth and 10th switches when said second clock is ON, a difference between the voltage charged in said sample capacitor and said reference voltage is amplified by a ratio of said sample capacitance and feedback capacitance and output, said operational amplifier is configured by 2 sets of source grounded input stages and 2 sets of current sources, switches which become the conductive state by said second clock are inserted in each set, and a bias current value and a gate width size of the input transistor are multiplied by (n+1) [n > 0, integer] in synchronization with said second clock.

The present invention alternatively has a first switch supplied with a first reference signal and operating ON/OFF by a first control signal; a second switch supplied with a first input signal and operating ON/OFF by a second control signal; a third switch supplied with a second reference signal and operating ON/OFF by said first control signal; a fourth switch supplied with a second input signal and operating ON/OFF by said second control signal; a first capacitor to which first output signals from said first and second switches are alternatively supplied in response to said first and second control signals; a second capacitor to which second output signals from said third and fourth switches are alternatively supplied in response to said first and second control signals; a first amplifier having outputs of said first and second capacitors connected to first and second input terminals, amplifying the same, and outputting the same from the first and second output terminals; a fifth switch and a third capacitor connected between said first input terminal and first output terminal; a sixth switch and a fourth capacitor connected between said second input terminal and second output terminal; a correction circuit to which said first and second input signals and a third reference signal are supplied and which outputs a correction signal for correcting the operation of said first amplifier to said third and fourth capacitors in response to said second control signal; and an operation setting circuit supplied with said second control signal and fixing the operation state of said amplifier during the second control signal is supplied.

The present invention alternatively has first, second, third, fourth, fifth, and sixth switches controlled by first and second clocks equal in sampling frequency and not overlapping each other and becoming the conductive state when said first clock is ON, seventh, eighth, ninth, and 10th switches which become the conductive state when said second clock is ON, an operational amplifier having a source grounded amplifier as the input stage and a capacitor for applying negative feedback to the operational amplifier, and a sample capacitor for sampling input signals via said third or fourth switch, wherein said first and second switches are connected in parallel to the capacitor for applying negative feedback to said operational amplifier, an input and output of said operational amplifier are short-circuited when said first clock is ON, a difference between the potential of a summing node and the input voltage is charged in said sample capacitor, a reference voltage for determining the operation point is supplied to said ninth and 10th switches when said second clock is ON, a difference between the voltage charged in said sample capacitor and said reference voltage is amplified by the ratio of said sample capacitance and said feedback capacitance and output, and provision is further made of a feed forward circuit connecting said input signal and the correction voltage in accordance with said reference voltage to said fifth and sixth switches.

The present invention alternatively has a first switch supplied with a first reference signal and operating ON/OFF by a first control signal; a second switch supplied with a first input signal and operating ON/OFF by a second control signal; a third switch supplied with a second reference signal and operating ON/OFF by said first control signal; a fourth switch supplied with a second input signal and operating ON/OFF by said second control signal; a first capacitor to which signals from said first and second switches are alternatively supplied in response to said first and second control signals; a second capacitor to which signals from said third and fourth switches are alternatively supplied in response to said first and second control signals; an amplifier having outputs of said first and second capacitors connected to first and second input terminals, amplifying the same, and outputting the same from the first and second output terminals; a fifth switch and a third capacitor connected between said first input terminal and first output terminal; a sixth switch and a fourth capacitor connected between said second input terminal and second output terminal; a correction circuit to which said first and second input signals and the third reference signal are supplied and which outputs a correction signal for correcting the operation of said amplifier to said third and fourth capacitors in response to said second control signal; and an operation setting circuit supplied with said second control signal and fixing the operation state of said amplifier for the period during which the second control signal is supplied.

The present invention alternatively is a sample-and-hold circuit comprised of first, second, third, fourth, fifth, and sixth switches controlled by first and second clocks equal in sampling frequency and not overlapping each other and becoming the conductive state at a point of time when the first clock is ON, seventh, eighth, ninth, and 10th switches which become the conductive state when said second clock is ON, an operational amplifier having a source grounded amplifier as the input stage, a capacitor for applying negative feedback to the operational amplifier, and a sample capacitor for sampling input signals via said third or fourth switch, wherein said first and second switches are connected in parallel to said capacitor for applying negative feedback to said operational amplifier, an input and output of said operational amplifier are short-circuited when said first clock is ON, a difference between the potential of the summing node and the input voltage is charged in said sample capacitor, said ninth and 10th switches are connected to the reference voltage for determining the operation point when said second clock is ON, and a difference between the voltage charged in said sample capacitor and said reference voltage is amplified by the ratio of said sample capacitance and said feedback capacitance and output, and provision is further made of a feedback circuit connecting an output common of said sample-and-hold circuit and a correction voltage in accordance with said reference voltage to said fifth and sixth switches.

The present invention is a pipeline AD converter cascade connecting a plurality of AD conversion sub blocks each of which is configured by an AD converter for converting an analog signal to a digital code, a DA converter for converting the digital code output by the AD converter to an analog value, and a sample-and-hold circuit for multiplying a difference between the analog signal applied to said AD converter and the analog signal output from said DA converter by $2^{(a-1)}$ [a: resolution of AD converter] and outputting the same, wherein said sample-and-hold circuit has first, second, third, fourth, fifth, and sixth switches controlled by first and second clocks equal in sampling frequency and not overlapping each other and becoming a conductive state at a point of time when said first clock is ON, seventh, eighth, ninth, and 10th switches which become the conductive state when said second clock is ON, an operational amplifier, a capacitor for applying negative feedback to the operational amplifier, and a capacitor for sampling input signals via said third or fourth switch, said first and second switches are connected in parallel to said capacitor for applying negative feedback to said operational amplifier, an input and output of said operational amplifier are short-circuited when said first clock is ON, a difference between the potential of the summing node and the input voltage is charged in the sample capacitor, a reference voltage for determining the operation point is supplied to said ninth and 10th switches when said second clock is ON, a difference between the voltage charged in said sample capacitor and said reference voltage is amplified by the ratio of said sample capacitance and feedback capacitance and output, said operational amplifier is configured by 2 sets of source grounded input stages and 2 sets of current sources, switches which become the conductive state by said second clock are inserted in each set, and the bias current value and the gate width size of the input transistor are multiplied by (n+1) [n > 0, integer] in synchronization with said second clock.

The present invention is a pipeline AD converter cascade connecting a plurality of AD conversion sub blocks each of which has an AD converter for converting an analog signal to a digital code, a DA converter for converting the digital code output by the AD converter to an analog value, and a sample-and-hold circuit for multiplying a difference between the analog signal applied to the AD converter and the analog signal output from the DA converter by $2^{(a-1)}$ [a: resolution of AD converter] and outputting the same, wherein said sample-and-hold circuit has first, second, third, fourth, fifth, and sixth switches controlled by first and second clocks equal in sampling frequency and not overlapping each other, and becoming the conductive state when the first clock is ON, seventh, eighth, ninth, and 10th switches which become the conductive state when said second clock is ON, an operational amplifier having a source grounded amplifier as the input stage, a capacitor for applying negative feedback to the operational amplifier, and a sample capacitor for sampling input signals via said third or fourth switch, said first and second switches are connected in parallel to the capacitor for applying negative feedback to said operational amplifier, an input and output of said operational amplifier are short-circuited when said first clock is ON, a difference between the potential of the summing node and the input voltage is charged in said sample capacitor, the reference voltage for determining the operation point is supplied to said ninth and 10th switches when said second clock is ON, a difference between the voltage charged in the sample capacitor and said reference voltage is amplified by the ratio of said sample capacitance and said feedback capacitance and output, the output of the circuit for detecting the difference between the common voltage of said input signal and said reference voltage and, at the same time, amplifying the difference voltage by the ratio of said sample capacitance and the feedback capacitance is connected to said fifth and sixth switches, and a polarity of the circuit is inverse to the polarity of said operational amplifier.

The present invention is a pipeline AD converter cascade connecting a plurality of AD conversion sub blocks each of which is configured by an AD converter for converting an analog signal to a digital code, a DA converter for converting the digital code output by the AD converter to an analog value, and a sample-and-hold circuit for multiplying a difference between the analog signal applied to the AD converter and the analog signal output from the DA converter by $2^{(a-1)}$ [a: resolution of AD converter] and outputting the same, wherein said sample-and-hold circuit is configured by first, second, third, fourth, fifth, and sixth switches controlled by first and second clocks equal in sampling frequency and not overlapping each other and becoming the conductive state at a point of time when the first clock is ON, seventh, eighth, ninth, and 10th switches which become the conductive state when said second clock is ON, an operational amplifier having a source grounded amplifier as the input stage, a capacitor for applying negative feedback to the operational amplifier, and a sample capacitor for sampling input signals via said third or fourth switch, wherein said first and second switches are connected in parallel to the capacitor for applying negative feedback to said operational amplifier, an input and output of said operational amplifier are short-circuited when said first clock is ON, a difference between the potential of the summing node and the input voltage is charged in said sample capacitor, said ninth and 10th switches are connected to the reference voltage for determining the operation point when said second clock is ON, and a difference between the voltage charged in the sample capacitor and said reference voltage is amplified by the ratio of said sample capacitance and said feedback capacitance and output, the output of the circuit for detecting the difference between the common voltage of said input signal and said reference voltage and amplifying the difference voltage by the ratio of said sample capacitance and the feedback capacitance is connected to said fifth and sixth switches, and the polarity of the circuit is inverse to the polarity of said operational amplifier.

EFFECT OF THE INVENTION

The sample-and-hold circuit of the present invention switches the current source of an amplifier and the sizes of amplification use transistors in accordance with the operation mode by using switches and makes the operation current variable so can reduce an operation mean current.
Further, by using this sample-and-hold circuit in a pipeline AD converter, the power consumption can be reduced.
The sample-and-hold circuit of the present invention increases the output dynamic range and in addition can suppress the input common mode fluctuation by providing a feed forward circuit in the amplifier.
Further, by using this sample-and-hold circuit in the pipeline AD converter, a stable conversion operation resistant to common mode fluctuation can be carried out.
The sample-and-hold circuit of the present invention can suppress the input common mode fluctuation by providing a feedback circuit in the amplifier.
Further, by configuring the amplifier as a source grounded type, the output dynamic range can be increased.
Further, by using this sample-and-hold circuit in a pipeline AD converter, a stable conversion operation resistant to common mode fluctuation can be carried out.

BRIEF DESCRIPTION OF THE DRAWINGS

[FIG. 1] A circuit diagram showing a sample-and-hold circuit of a conventional example.
[FIG. 2] An operation timing chart for explaining the operation of the sample-and-hold circuit shown in FIG. 1.
[FIG. 3] A circuit diagram showing the circuit configuration of an amplifier used in the sample-and-hold circuit shown in FIG. 1.
[FIG. 4] A circuit diagram showing the configuration of another sample-and-hold circuit of a conventional example.
[FIG. 5] An overall block diagram showing the configuration of a sample-and-hold circuit of the present invention.
[FIG. 6] An operation timing chart for explaining the sample-and-hold circuit shown in FIG. 5.
[FIG. 7] An overall block diagram showing the configuration of a sample-and-hold circuit of the present invention.
[FIG. 8] A circuit diagram showing a common mode and/or feed forward circuit configuration formed in the sample-and-hold circuit shown in FIG. 7.
[FIG. 9] An operation timing chart for explaining the operation of the sample-and-hold circuit shown in FIG. 8.
[FIG. 10] An overall block diagram showing the configuration of the sample-and-hold circuit of the present invention.
[FIG. 11] A circuit diagram showing the common mode and/or feed forward circuit configuration formed in the sample-and-hold circuit shown in FIG. 10.
[FIG. 12] An overall block diagram showing the configuration of a pipeline AD converter.
[FIG. 13] A circuit diagram showing the configuration of an MDAC circuit used in the pipeline AD converter shown in FIG. 12.
[FIG. 14] A circuit diagram showing the configuration of another MDAC circuit used in the pipeline AD converter shown in FIG. 12.
[FIG. 15] A circuit diagram showing the configuration of another MDAC circuit used in the pipeline AD converter shown in FIG. 12.

DESCRIPTION OF NOTATIONS

10, 100, 150, 200, 300, 414, 421 ··· S/H (sample-and-hold) circuits, 11 ··· amplifier, 50, 251, 351 ··· operational amplifiers (amplifiers), 51, 302, 350 ··· CMFB (common mode feedback) circuits, 202, 250 ··· CMFF (common mode feed forward) circuits, 400 ··· pipeline AD converter, 402A to 402N, 403A to 403N ··· input circuits, 410, 422A to 422D ··· MDAC (Multiplying DAC), 411 ··· AD converter (ADC), 412 ··· DA converter (DAC), 413 ··· subtractor, and 423 ··· error correction/clock generation circuit.

BEST MODE FOR WORKING THE INVENTION

(Embodiment 1)

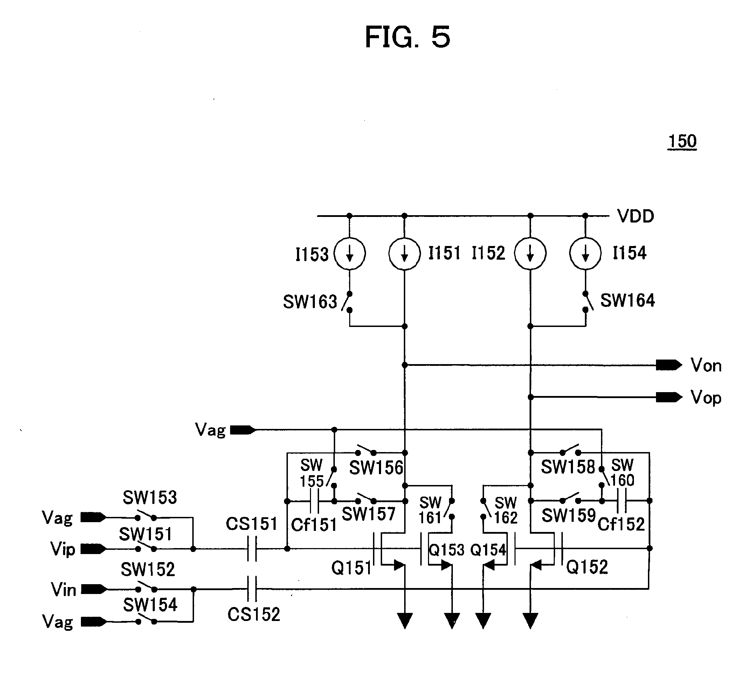

A sample-and-hold circuit 150 according to an embodiment of the present invention is shown in FIG. 5.
One side of a current source I151 is connected to the voltage source VDD, the other side is connected to the drain of an NMOS transistor Q151, and a current source I153 and a switch SW163 are serially connected in parallel to the current source I151. The current source I153 is the current source for flowing a current n times the current source I151. The source of the NMOS transistor Q151 is connected to the ground, an SW156 is connected between the gate and the drain. In parallel to this, a serially connected SW157 and capacitor Cf151 are connected. The common connection point of these capacitor Cf151 and SW157 is connected via SW155 to Vag.

A source grounded type NMOS transistor Q153 is provided in parallel to the NMOS transistor Q151 configuring a pseudo differential circuit, the gate of this is commonly connected to the gate of Q151, and the drain is connected via an SW161 to the drain of Q151.

Further, one side of a current source I152 is connected to the voltage source VDD, and the other side is connected to the drain of the NMOS transistor Q152. Further, in parallel to the current source I152, a current source I154 and an SW164 are connected in series. The current source I154 is the current source for passing a current n times the current source I152.

The source of the NMOS transistor Q152 is connected to the ground, an SW158 is connected between the gate and the drain, and, in parallel to this, a serially connected SW159 and capacitor Cf152 are connected. The common connection point of these capacitor Cf152 and SW159 is connected via an SW160 to Vag.

Also, an NMOS transistor Q154 is configured in the same way as the NMOS transistor Q153. Namely, parallel to the NMOS transistor Q152, the source grounded type NMOS transistor Q154 is provided, the gate of this is commonly connected to the gate of Q152, and the drain is connected via an SW162 to the drain of the Q152.

Here, where the gate widths of the NMOS transistors Q153 and Q154 are set to n times the gate widths of the NMOS transistors Q151 and Q152, and the drain current flowing in the NMOS transistors Q151 and Q152 is I0, a drain current of n*I0 flows.

Gates of the NMOS transistors Q151 and Q153 are connected to the capacitor CS151 and further connected via an SW151 to Vip and connected via an SW153 to Vag.

Gates of the NMOS transistors Q152 and Q154 are connected to the capacitor CS152 and further connected via an SW152 to Vin and connected via an SW154 to Vag.

Then, drains of the NMOS transistors Q151 and Q152 are connected to the outputs Von and Vop.

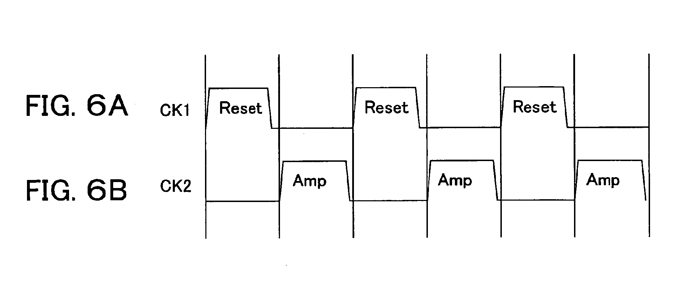

Next, an explanation will be given of the basic operation of the sample-and-hold circuit 150 of the present invention shown in FIG. 5 by using the timing waveforms shown in FIG. 6.

At the time of the reset mode, in FIG. 6A, the CK1 becomes the "H" level, and the CK2 of FIG. 6B becomes the "L" level. As switches at that time, the SW151, SW152, SW155, SW156, SW158, and SW160 are ON state, and the SW153, SW154, SW157, SW159, SW161, SW162, SW163, and SW164 become OFF state.

The SW163 and SW164 become OFF, therefore the current sources of the NMOS transistors Q151 and Q152 are the I151 and I152 having the current value of I0. These flow as drain currents via sources to the ground.

Further, the SW161 and SW162 become OFF, therefore, as explained above, only the NMOS transistors Q151 and Q152 operate.

The gates and drains of the input/output terminals of the NMOS transistors Q151 and 152 are short-circuited, so the transistors operate as MOS diodes.

The SW157 and SW159 become OFF, therefore the Vag voltage is supplied to the feedback capacitors Cf151 and Cf152 and precharge these capacitors.

On the input side of the operational amplifier, the SW151 and SW152 are ON and short-circuited, therefore Vip is supplied to the input capacitor CS151 and charged with respect to Vgs of the NMOS transistor Q151 (MOS diode).

On the other hand, Vin is supplied via the SW152 to the input capacitor CS152 and charged to the NMOS transistor Q152 (MOS diode).

In this way, the present circuit reduces the current amount by switching the switches when the sample-and-hold circuit is in the reset mode and, at the same time, multiplies the sizes (gate widths) of the transistors by 1/(n+1) to make the current densities always equal.

This is because when only the current value is changed, but the sizes of the transistors are not changed along with that, the magnitude of the voltage Vgs between the gate and the source changes and becomes equivalent to the change of the input common voltage. As a result, there arises a problem that the output operation point shifts since this amount of change is amplified in the input stage of the source grounded type amplifier.

In order to prevent such a problem, in the configuration of the present invention, switches were provided and the sizes of transistors were made variable so that current densities become constant when switching current sources.

Next, an explanation will be given of the time of the amplification mode. In FIG. 6A, the CK1 is at the "L" level, and in FIG. 6B, the CK2 is at the "H" level.

At this time, the SW151, SW152, SW155, SW156, SW158, and SW160 are OFF, and the SW153, SW154, SW157, SW159, SW161, SW162, SW163, and SW164 become ON.

The SW163 becomes ON, therefore the current source becomes (1+n)*I0 of the total of I151 and I153. This current flows in the source grounded NMOS transistors Q151 and Q153. Further, the SW164 also becomes ON, therefore the drain current of the current source (1+n) *I0 of the total of I152 and I154 flows in the NMOS transistors Q152 and Q154.

Gates and drains of input/output terminals of the NMOS transistors Q151 and Q153, and Q152 and Q154 become open in terms of DC, whereby the transistors change from diodes to amplifiers.

The Vag is supplied via the SW153 to the input capacitor CS151. Then, the feedback capacitor Cf151 stores a charge corresponding to the voltage obtained by gain (CS151/Cf151) multiplying the voltage difference from the input voltage Vin to the Vag and the charge precharged in the Cf151.

In the same way, Vag is supplied via the SW154 to the input capacitor CS152. The feedback capacitor Cf152 stores a charge corresponding to the voltage obtained by gain (CS152/Cf152) multiplying the voltage difference between Vin and Vag and the charge precharged in the Cf152.

As explained above, at the time of the amplification mode, the operation current of the current source was multiplied by (1+n) in comparison with the reset mode, then the sizes of the transistors were multiplied by (1+n) along with that, therefore a high speed operation could be carried out, and the Vgs between the gate and the source was made constant at that time, so the fluctuation of same phase voltages corresponding to the common mode on the input side could be prevented.

Further, by making the operation current I0 in the reset mode, multiplying I0 by (1+n) in the amplification mode, and switching the current value in accordance with the operation mode to achieve an efficient operation, the mean operation current could be reduced.

An example of the sample-and-hold circuit 150 of the embodiment explained above using the NMOS transistors was shown. Other than this, the circuit can be configured by PMOS transistors too and further can be configured by FETs using insulation gates.

(Embodiment 2)

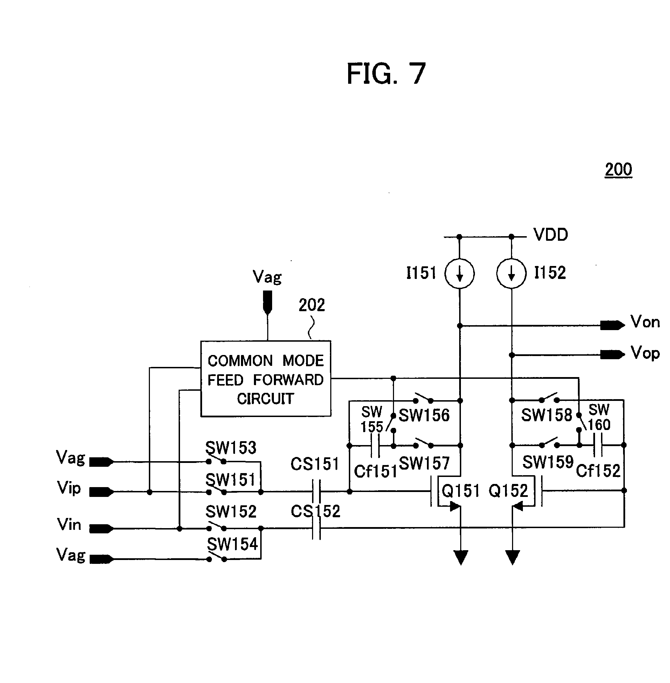

Next, a sample-and-hold circuit 200 as another embodiment of the present invention is shown in FIG. 7. Here, elements indicating same configurations as those in FIG. 5 are served with same notations. Further, this sample-and-hold circuit 200 has a configuration obtained by adding a common mode feed forward (CMFF) circuit to the circuit formed by deleting a portion of FIG. 5.

Hereinafter, for simplifying the circuit configuration and its explanation, only one MOS transistor is shown as the source grounded transistor, but other MOS transistors may be connected in parallel by using switches, and switch(SW) and current source may be provided in parallel also in the constant current source corresponding to this.

The input of the CMFF circuit 202 is connected to Vip and Vin and connected also to Vag. The output of the CMFF circuit 202 is connected to the common connection point of the capacitor Cf151 and the SW157 and the common connection point of the capacitor Cf152 and the SW159 via SW155 and SW160. The rest of the circuit configuration is the same as that of the sample-and-hold circuit 150 of FIG. 5, so the explanation thereof is omitted here.

Next, the basic operation for the sample-and-hold circuit 200 shown in FIG. 7 will be explained by using the timing waveforms shown in FIG. 6.

In the reset mode, in FIG. 6A, the CK1 becomes the "H" level, and the CK2 in FIG. 6B becomes the "L" level. As switches at that time, the SW151, SW152, SW155, SW156, SW158, and SW160 are ON, and the SW153, SW154, SW157, and SW159 become OFF.

As a result, the gates and drains of the input/output terminals of the NMOS transistors Q151 and Q152 are short-circuited. The SW151 and SW152 are ON and short-circuited, therefore Vip and Vin are supplied to the input capacitors CS151 and CS152 and charged. On the other hand, these Vin and Vip are supplied to also the CMFF circuit 202. The CMFF circuit 202 has the function of detecting the difference between the voltage Vag and the input common voltage (Vcmn= (VIn+Vip)/2) and amplifying the difference voltage to a multiple of the gain of the sample-and-hold circuit (here, CS151/Cf151). The VCMMD of the correction signal generated in this CMFF circuit 202 is applied via the SW155 and SW160 to the common connection point of the SW157 and Cf151 and the common connection point of the SW159 and the Cf152.

In the case of the reset mode, the SW157 and SW159 become OFF, therefore, in the feedback capacitor Cf151, VCMMD is charged to the Vgs of the MOS transistor Q151. In the feedback capacitor Cf152, VCMMD is charged to the Vgs of the MOS transistor Q152.

Further, the Vip is supplied via the SW151 to the input capacitor CS151, and the input capacitor CS151 is charged with respect to the Vgs of the MOS transistor Q151.

On the other hand, the Vin is supplied via the SW152 to the input capacitor CS152, and the input capacitor CS152 is charged with respect to the Vgs of the MOS transistor Q152.

In this way, when the sample-and-hold circuit is in the reset mode, this circuit previously precharges the correction voltage VCMMD thereof via the switch (SW) 155 and the switch (SW) 160 to the feedback capacitors Cf151 and Cf152.

Next, an explanation will be given of the amplification mode. In FIG. 6A, the CK1 becomes the "L" level, and in FIG. 6B, the CK2 becomes the "H" level.

At this time, the SW exhibits the inverse operation state to that at the time of the reset mode. As a result, the input/output terminals and gates and drains of the NMOS transistors Q151 and Q152 become open in terms of DC, and the operation becomes amplification state.

By switching switches of the input ends, the amounts of changes from Vip and Vin to Vag are transmitted to the NMOS transistors Q151 and Q152 via the input capacitor CS151 and CS152. The amounts of changes are multiplied by CS151/Cf151 (or CS152/Cf152) and output to the Vop and Von. At this time, as previously explained, in the Cf151 and Cf152, the VCMMD is previously precharged, therefore this correction voltage is added to the output voltage.

For example, assuming that for example a fluctuation of ΔV occurs in the input common, the output operation point of the sample-and-hold circuit fluctuates by exactly -ΔV(Cs/Cf) in the amplification mode. Contrary to this, by generating ΔV(Cs/Cf) at the CMFF circuit 202 and previously precharging it to the feedback capacitors in the reset mode of the sample-and-hold circuit, the amounts of fluctuation cancel each other each in the amplification mode, so the operation point of the operational amplifier will not change.

As the sample-and-hold circuit 200 of the above embodiment, an example using NMOS transistors was shown, but other than these, the circuit may be configured by PMOS transistors and further may be configured by other insulation gate field effect transistors.

(Embodiment 3)

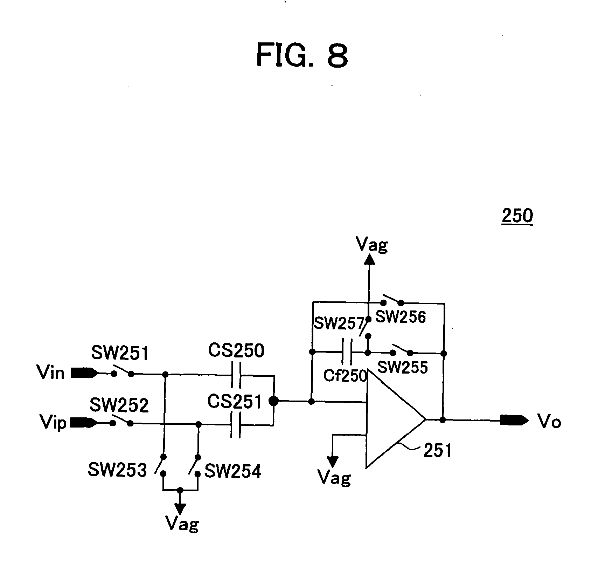

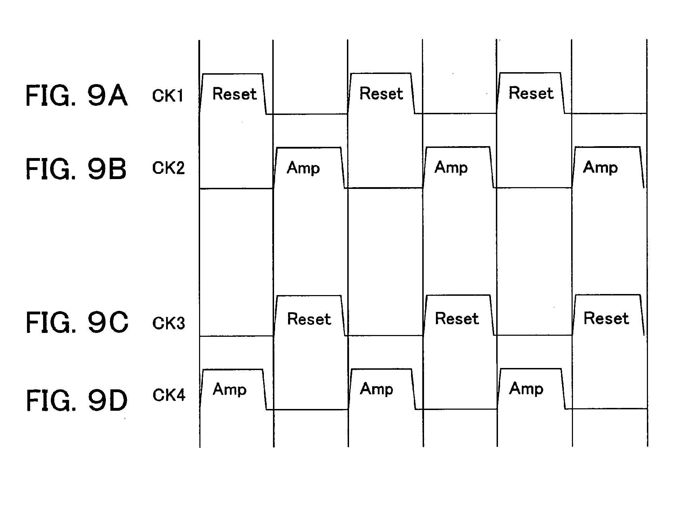

FIG. 8 shows a CMFF circuit 250 of the embodiment. The CMFF circuit 250 corresponds to the CMFF circuit 202 configured in the sample-and-hold circuit 200 explained before. The timing for explaining the operation thereof is shown in FIG. 9. Clock signals (CK3, CK4) supplied to the CMFF circuit 250 (202) operate as inverse phase clocks to the control clock signals (CK1, CK2) of the sample-and-hold circuit 200.

In FIG. 8, the input terminal supplied with Vin is connected to one end of an SW251, and the other end of the SW251 is connected to a capacitor CS250. Further, the common connection point of this SW251 and the capacitor CS250 is connected via an SW253 to the Vag.

The input terminal supplied with Vip is connected to one end of an SW252, and the other end of the SW252 is connected to a capacitor CS251. Further, the common connection point of this SW252 and the capacitor CS251 is connected via an SW254 to the Vag.

The other ends of the capacitors CS250 and CS251 are commonly connected and connected to one input terminal of the operational amplifier 251. The other input terminal of this operational amplifier 251 is connected to the Vag. An SW256 is connected between the output of the operational amplifier 251 and one input terminal, and further a capacitor Cf250 and an SW255 are serially connected in parallel to the SW256. The common connection point of the capacitor Cf250 and the SW255 is connected via an SW257 to the Vag.

When the CMFF circuit is in the reset mode, the sample-and-hold circuit 200 shown in FIG. 7 is in the amplification mode, and the CK2 of FIG. 9 is at the "H" level. The relationships thereof are shown in FIG. 9A to FIG. 9D. In FIG. 9C and FIG. 9D, the CK4 becomes the "L" level when the CK3 is at the "H" level, therefore, the SW253, SW254, SW256, and SW257 become ON, and the SW251, SW252, and SW255 become OFF.

Accordingly, the SW253 and SW254 are ON and connected to Vag, and Vag is input to the sample capacitors CS250 and CS251 of the CMFF circuit 250, but the input/output terminal of the operational amplifier 251 is Vag, therefore charges are not stored.

Next, when the CMFF circuit 250 is in the amplification mode, the CK3 becomes the "L" level, and the CK4 becomes the "H" level (FIG. 9C, FIG. 9D). As a result, the SW253, SW254, SW256, and SW257 become OFF, and the SW251, SW252, and SW255 become ON.

The SW251 and SW252 become ON, Vin and Vip are supplied to the CS250 and CS251, and a mean voltage (Vin+Vip)/2 obtained by adding these is output to the common connection point of the capacitors CS250 and CS251 and supplied to one input of the operational amplifier 251. The other input of the operational amplifier 251 is connected to the Vag, therefore the difference between this common voltage (=(Vin+Vip)/2) and the Vag is multiplied by (CS250+CS251)/Cf250 and output from the output Vo of the operational amplifier 251 as the VCMMD voltage. In the CMFF circuit 250, the Vag is sampled beforehand, then the switching to the input voltage is carried out, therefore the amount of change of the common voltage has the same magnitude as the amount of the common change occurring in the sample-and-hold circuit, but has a different polarity.

Note that for the sample capacitors CS250 and CS251 determining the gain of the CMFF circuit 250 and the feedback capacitor Cf250, it is not necessary to use the same values as the capacitances used in the sample-and-hold circuit. These CS250, CS251, and Cf250 may have almost the same capacitance ratio as that used in the sample-and-hold circuit 200. The CS250 and CS251 can be selected to small values in comparison with capacitance values of the input capacitors CS151 and CS152 of the sample-and-hold circuit, and Cf152 can be selected to a small value in comparison with the capacitance value of the feedback capacitors Cf151 and Cf152.

Further, the gain of the operational amplifier 251, in the same way, does not have to be a high gain. It is enough that it generally coincide with the gain of the sample-and-hold circuit 200 as a total gain of the CMFF circuit 202.

(Embodiment 4)

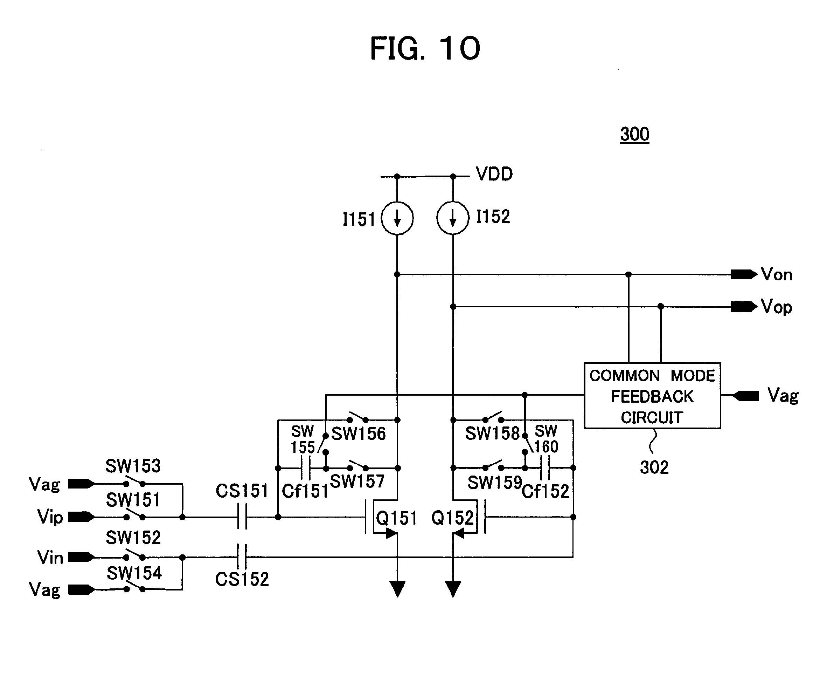

Next, a sample-and-hold circuit 300 of another embodiment of the present invention is shown in FIG. 10. In the circuit in FIG. 10, the same components as those in FIG. 5 are given the same notations.

A sample-and-hold circuit 300 has the sample-and-hold circuit 200 shown in FIG. 7 with the CMFF circuit 202 replaced with a CMFB circuit 302 connected between the outputs of MOS transistors Q151 and Q152 and the SW15 and SW160, therefore a detailed explanation will be omitted. Further, this CMFB circuit 302 further receives as input the Vag.

Next, the basic operation of the sample-and-hold circuit 300 using an operational amplifier having a source grounded pair transistors according to the embodiment of the present invention shown in FIG. 10 will be explained by using the timing waveforms shown in FIG. 6.

An explanation will be given of the operation in the case of the reset mode. In FIG. 6A, the CK1 becomes the "H" level, and the CK2 of FIG. 6B becomes the "L" level. The switch operations at that time are same as those in FIG. 7 explained before.

As a result, the gates and drains of input/output terminals of the NMOS transistors Q151 and Q152 are short-circuited, and the transistors operate as the MOS diodes. Further, at this time, the voltages of the connection points of the input capacitors CS151 and CS152 and the MOS transistors (diodes) Q151 and Q152 are fixed to Vgs, and the impedances of these connection points become low.

The SW151 and SW152 are ON and short-circuited, therefore Vip and Vin are supplied to the input capacitors CS151 and CS152 and charged with respect to Vgs of the MOS diodes Q151 and Q152. On the other hand, the CMFB circuit 302 supplies the difference between the voltage Vag and the common voltage (Vcmn=(Von+Vop)/2) of the output voltages output from the sample-and-hold circuit at the time of the amplification mode a half period (cycle) before the present period (cycle) via the SW155 and SW160 to the Cf151 and Cf152 as VCMMD voltages.

Further, Vip is supplied via the SW151 to the input capacitor CS151 and charged in the CS151 with respect to Vgs of the MOS diode (Q151). In the same way, in also the input capacitor CS152, Vin is charged with respect to Vgs of the MOS diode (Q152).

Next, an explanation will be given of the time of the amplification mode. In FIG. 6A, the CK1 becomes the "L" level, and in FIG. 6B, the CK2 becomes the "H" level. The switch operations at that time become inverse operation states to those at the time of the reset mode.

As a result, the gates and drains of input/output terminals of the NMOS transistors Q151 and Q152 become open in terms of DC and become the amplification operation state.

Vag is supplied from the SW153 and SW154 to the input capacitors CS151 and CS152. The amounts of changes relative to the voltages (Vip, Vin) charged at the time of the reset are transmitted to the operational amplifier. On the other hand, the output voltage from the CMFB circuit 302 is not supplied to the common connection point of the SW157 and the Cf151 and the common connection point of the SW159 and the Cf152 since the SW155 and SW160 have become OFF.

However, the feedback capacitors Cf151 and Cf152 already store the common mode correction voltage VCMMD corresponding to the differential voltage of (Von+Vop)/2 output from the CMFB circuit 302 in the reset mode and Vag. This VCMMD voltage is used for correcting the output operation point in the amplification mode.

As a result, VCMMD is added to a value obtained by multiplying the difference between Vip and Vag by the gain of CS151/Cf151, and the result is output. Further, also for the NMOS transistor Q152, in the same way, as the voltage on the output side of the Cf152, the VCMMD is added to a value obtained by multiplying the difference between Vin and Vag by the gain of CS152/Cf152, and the result is output.

In this way, when assuming that the fluctuation of ΔV occurs in the output common in the amplification mode (for example n-th amplification mode), the CMFB circuit 302 generates -ΔV. At the time of the next reset mode (for example n+1-th reset mode), by precharging the feedback capacitor, the amounts of fluctuations cancel each other out at the time of further next amplification mode (for example n+1-th amplification mode), and the operation point of the operational amplifier will not change.

Note that the deviation of the common voltage is detected from the voltages (Von, Vop) at the time of the amplification mode of the sample-and-hold circuit 300 as explained before, therefore, the correction of the amount of change is carried out in the amplification mode one period (cycle) after the present period (cycle).

Below, in the same way, the reset operation and the amplification operation are alternately repeated.

In this way, when the sample-and-hold circuit is in the reset mode state, the CMFB circuit 302 previously charges the difference voltage as the common mode correction use VCMMD voltage in the capacitors Cf151 and Cf152 of the feedback capacitances via the switch (SW) 155 and the switch (SW) 160.

As the sample-and-hold circuit 300 of the above embodiment, the example of using NMOS transistors was shown, but other than these, the circuit may be configured by PMOS transistors and further may be configured by other insulation gate field effect transistors.

(Embodiment 5)

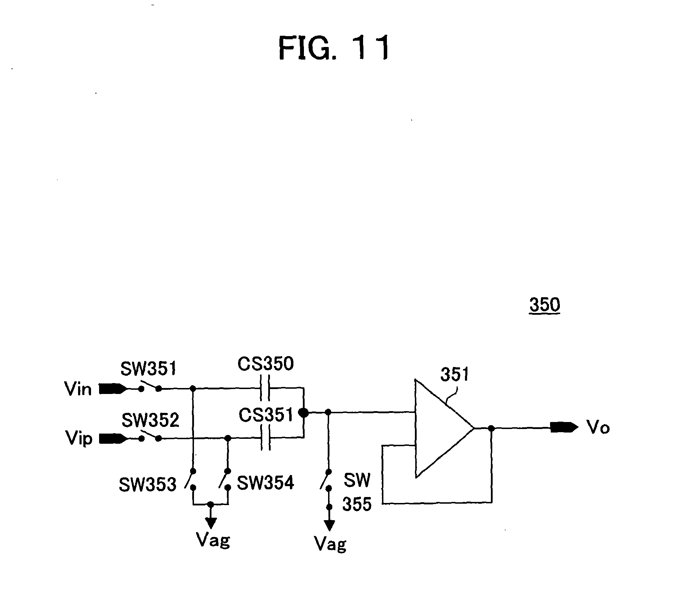

FIG. 11 shows a CMFB circuit 350 (302) of the embodiment. This CMFB circuit 350 operates by inverse phase clocks (CK3, CK4) to the control clock signals (CK1, CK2) of the sample-and-hold circuit.

In FIG. 11, the input terminal(Vin) supplied with a negative output voltage Von of the sample-and-hold circuit (300) is connected to one end of an SW351, and the other end of the SW351 is connected to a capacitor CS350. Further, the common connection point of these SW351 and capacitor CS350 is connected via an SW353 to the Vag.

The input terminal(Vin) supplied with a positive output voltage Vop of the sample-and-hold circuit (300) is connected to one end of an SW352, and the other end of the SW352 is connected to a capacitor CS351. Further, the common connection point of these SW352 and capacitor CS351 is connected via an SW354 to the Vag.

The other ends of the capacitors CS350 and CS351 are commonly connected and connected to one input terminal of the operational amplifier 351, and this common connection point is connected via an SW355 to Vag. The output terminal of the operational amplifier 351 is connected to the other input terminal and this circuit configuration forms the voltage follower circuit.

An explanation will be given of the operation of the CMFB circuit 350 by using FIG. 9 and FIG. 11. When the sample-and-hold circuit 300 is at the time of the amplification mode, the CMFB circuit 350 is in the reset mode, the CK3 becomes the "H" level, and the CK4 becomes the "L" level (FIG. 9C, FIG. 9D). As a result, the SW351, SW352, and SW355 become ON, and the SW353 and SW354 become OFF.

The SW351 and SW352 and SW355 become ON, and output voltages Von and Vop of the sample-and-hold circuit are supplied to the CS350 and CS351 and charged with respect to Vag.

Next, when the sample-and-hold circuit 300 is in the reset mode and when the CMFB circuit 350 is in the amplification mode, the CK3 becomes the "L" level and the CK4 becomes the "H" level (FIG. 9C, FIG. 9D). As a result, the SW351, SW352, and SW355 become OFF, and the SW353 and SW354 become ON.

The SW353 and SW354 become ON, therefore Vag is supplied to the input capacitors CS350 and CS351, and the amounts of changes from the preceding charged output voltage of the sample-and-hold circuit are transmitted to the input end of the voltage follower circuit. As a result, since the input capacitors CS350 and CS351 are commonly connected, the mean voltage of these amounts of changes (Von+Vop)/2 is output from the voltage follower circuit.

The present CMFB circuit 350 samples the output voltages Von and Vop of the sample-and-hold circuit 300 beforehand, then switches to Vag, therefore although its magnitude is the same as the amount of the common change occurring in the output of the sample-and-hold circuit 10, their polarities are different.

When the sample-and-hold circuit 300 is in the reset mode, this CMFB circuit 350 precharges the difference between the output common mode voltage at the time of the amplification mode a half period (cycle) before the present period (cycle) and the Vag via the SW155 and SW160 to the feedback capacitors Cf151 and Cf152.

In this way, by previously charging the feedback capacitors at the time of the reset mode of the sample-and-hold, the amounts of fluctuations cancel each other out at the time of the next amplification mode to thereby prevent the operation point of the operational amplifier from changing.

Note, in order to detect the deviation of the common voltage from the output voltage at the time of the amplification mode of the sample-and-hold circuit 300, the amount of change is corrected in the amplification mode one period (cycle) after the present period (cycle).

(Embodiment 6)

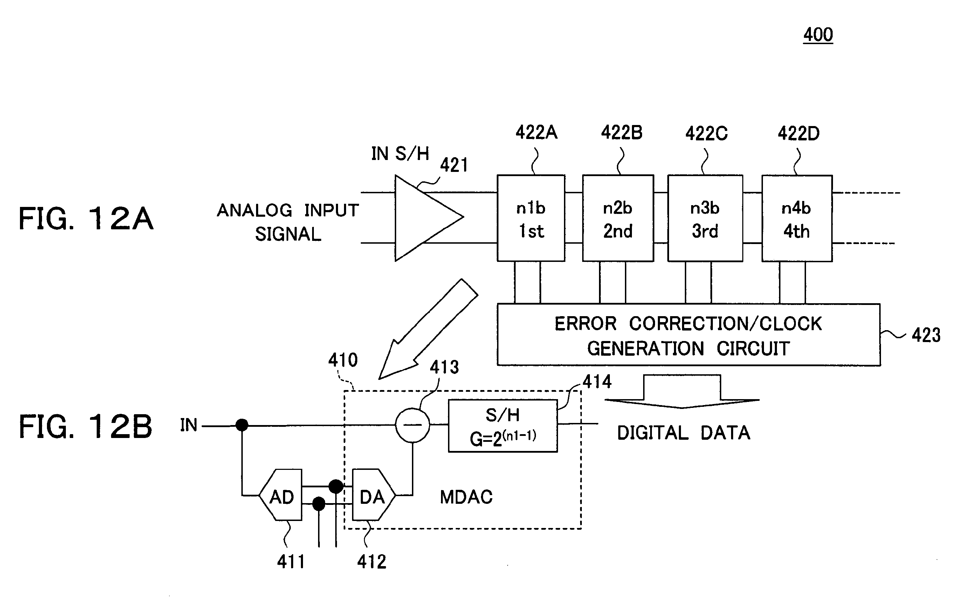

FIG. 12 shows an example of the pipeline AD converter 400. In an initial stage, a sample-and-hold (S/H) circuit 421 is arranged, and n-bit/stage bit blocks (422A, 422B, 422C, 422D, ...) are cascade connected in accordance with the resolution after that. The digital data AD converted from the bit blocks are added to each other at an error correction/ clock generation circuit 423 and output after the error correction.

The n-bit/stage bit blocks (422A, 422B, 422C, 422D, ⋯) have the n-bit ADC 411 and DAC 412 and a sample-and-hold circuit 414 for amplifying a difference between the input analog voltage and the output voltage reproduced from the DAC 412 by $2^{(n-1)}$ times. The DAC, subtractor, amplifier, and hold circuit can be realized by one circuit called a MDAC (multiplying DAC) 410 which is frequently used in a pipeline ADC (converter). In this MDAC 410, the above three types of S/H circuits (150, 200, 300) of the embodiments of the present invention can be applied.

Next, an explanation will be given of the basic operation of this pipeline AD converter 400. When the analog input signal (analog in) is input to the sample-and-hold (S/H) circuit 421, analog signals are sampled in synchronization with the sample clock in the sampling period. The sampled analog signals are held at the next timing (clock).

Signals held in the S/H circuit 421 are input to the bit block 422A, and analog signals are converted to digital signals with a predetermined precision (bit). As the bit precision of this AD converter 411, there are 1.5 bit or 2, 3, or 4 bits etc., and the precision is selectively used in each bit block.

A flash type configuration is used for the configuration of the AD converter 411. It performs a high speed operation so that the pipeline operation can be achieved. For this reason, the number of comparators is proportional to a power of 2 of the number of bits, therefore the number of bits is decreased as much as possible. The number of comparators becomes 2 at the time of 1.5 bit, becomes 3 at the time of 2 bits, becomes 7 at the time of 3 bits, ···. The larger the number of comparators, the larger the chip area, therefore this is determined considering the number of bit block stages and the bit precision.

The data converted to the digital signal at the AD converter 411 is supplied to the error correction/clock generation circuit 423 shown in FIG. 12 and, at the same time, supplied to the DA converter 412 configuring the MDAC 410.

The digital signal is converted to an analog signal at the DA converter 412 and supplied to the subtractor 413 where it is subtracted with the held input analog signal. Namely, as the signal output from this subtractor 413, a difference signal obtained by subtracting the signal at an upper significant bit (422A) from the input analog signal is output. This difference signal is supplied to the S/H circuit 414, gain multiplied there by the (n1-1) power of 2, then this amplified signal is held. Next, the analog signal held at the S/H circuit 414 of the bit block 422A is supplied to a bit block 422B in the next stage, the same operation as that explained in 422A is carried out, and further finer quantization is carried out. Below, this operation will be repeated in synchronize with to the clock timing output from the error correction/clock generation circuit.

Each bit block explained above has the sample-and-hold function, therefore bit blocks sequentially perform the conversion with respect to input signals sequentially continuing in terms of time, and a high speed conversion operation becomes possible. Namely, for example when the bit block 422A is performing the AD conversion operation, the bit block 422B in the next stage performs the AD conversion of the analog signal sampled one time before the signal AD converted by the bit block 422A.

In this way, analog signals sampled in a time sequence of exactly the number of stages of bit blocks are simultaneously AD converted, and the AD converted data can be extracted as successive digital data from the error correction/clock generation circuit 423 in synchronize with the clock timing.

(Embodiment 7)

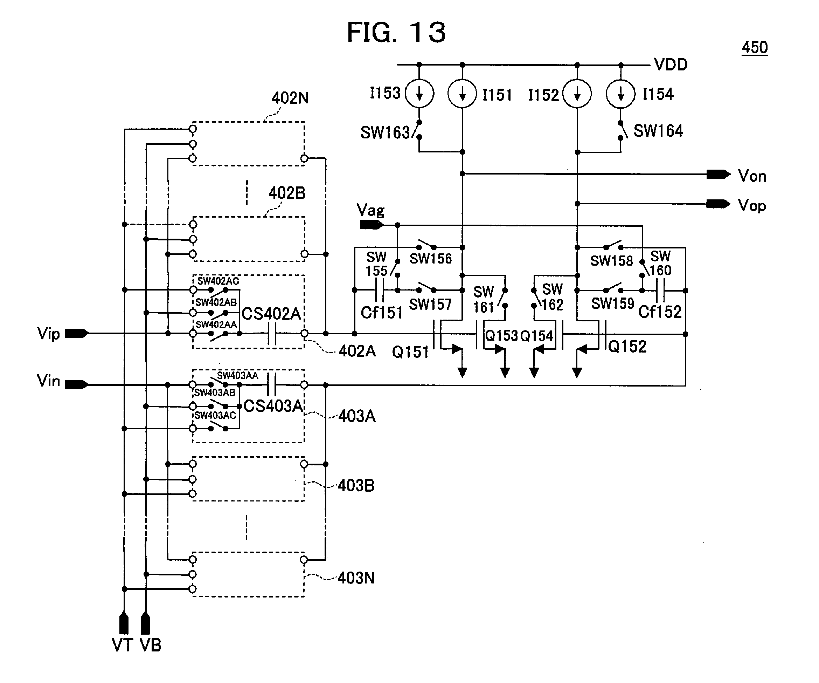

The MDAC 450 of another embodiment is shown in FIG. 13. In the MDAC 450, as shown in FIG. 12, the functions of the DA converter 412, the subtractor 413, and the S/H circuit 414 are realized by one circuit. Elements of the MDAC 450 in FIG. 13 having the same configurations as those of the S/H circuit 150 of FIG. 5 are given the same notations.

Further, the S/H circuit has the same circuit configuration as that in FIG. 5, therefore the explanation thereof is omitted, and an explanation will be mainly given of the configuration of the DA converter (412) connected to the input thereof.

The gate of the NMOS transistor Q151 configuring the source ground is connected to input circuits 402A, 402B,···, 402N. The gate is connected to for example a capacitor CS402A of this input circuit 402A and further connected via an SW402AA to the input signal Vip and connected via SW402AB and SW402AC to reference voltages VT and VB. 402B, ···, 402N are connected in the same way.

The gate of the NMOS transistor Q152 is connected to input circuits 403A, 403B, ···, 403N. The gate is connected to for example a capacitor CS403A configuring this input circuit 403A and further connected via an SW403AA to the Vin, connected via an SW403AB to the reference voltage VB, and connected via an SW403AC to the reference voltage VT. Also input circuits 403B,···, 403N are connected in the same way.

Drains of the NMOS transistors Q151 and Q153 and Q152 and Q154 are connected to the outputs Von and Vop.

Sample capacitors CS402A to 402N, and CS403A to 403N provided in the input circuits 402A, 402B, ···, 402N, 403A, 403B, ···, and 403N are provided in accordance with the resolution of the AD conversion of the bit blocks and connected to the reference voltages VT or VB in response to thermometer code outputs of AD of the bit blocks.

Next, an explanation will be given of the operation of the MDAC 450. Assume now that the input circuits 402A and 403A are selected at the AD converter 411.

At the time of the reset mode, referring to FIG. 6A and FIG. 6B, the CK1 becomes the "H" level, and the CK2 becomes the "L" level. The switch operation state at that time is the same as that of the S/H circuit 150 in FIG. 5. Further, the SW402AA and SW403AA become ON, and the SW402AB, SW402AC, SW403AB, and SW403AC become OFF. Note that the SW402AB, SW402AC, SW403AB, and SW403AC are controlled by the ADC 411. They perform the switch operation so that either one of VT or VB is selected.

Then, only NMOS transistors Q151 and Q152 operate, then the operation currents thereof are set at I151 and I152, so they operate as MOS diodes.

The Vag are supplied to the Cf151 and Cf152 via the SW155 and SW160, and Vag are charged with respect to Vgs of the NMOS transistors Q151 and Q152 (MOS diodes).

For example, assuming that the input circuit 402A is selected, the switch SW402AA is ON, therefore the output voltage from the MDAC (410) of the bit block in the former stage is now supplied as the input voltage, for example Vip. This is supplied via this switch to the sampling capacitor CS402A and charged with respect to Vgs of the NMOS transistor Q151 (MOS diode).

However, another two SWs (SW402AB and SW402AC) are OFF, therefore thermo-voltages (reference voltage sources VB, VT) in response to the thermometer code outputs of the AD converter are not supplied. Further, the same operation is carried out for also the input circuits 403A (to 403N) supplied with Vin.

Next, at the time of the amplification mode, the operation of each SW becomes the inverse operation state to that at the time of reset. As a result, the NMOS transistors Q151, Q153, and Q152 and Q154 become the amplification operation state. Further, the SW402AB, SW402AC, SW403AB, SW403AC, etc. are operated ON/OFF by control signals from the ADC 411 and connected to either one of VT or VB. As a result, input signals sampled at the time of the reset via input capacitors and amounts of changes from VT or VB are transmitted to the operational amplifier. These amounts of changes are gain multiplied at the MDAC 410 (=CS402/Cf151, here, CS402=CS402A+CS402B + ··· + CS402N) and output.

In this way, at the time of the amplification mode, I151 and I153 and I152 and I154 of the current source are simultaneously supplied, the operation current of each amplifier is set as (1+n)*I0, and high speed operation can be carried out in comparison with the operation in the reset period.

On the other hand, as the NMOS transistors configuring the amplifier, Q151 and Q153 and Q152 and Q154 are connected in parallel. The current densities are made constant and Vgs are made constant and, at the same time, high speed operation can be carried out by using an increasing current from the above constant current source.

Below, in the same way, the same operation is repeated among bit blocks, and operations of AD conversion are carried out in synchronization with the clock timing.

In this way, in the reset mode, the operation current value of the amplifier was suppressed to 1/(1+n) times, and the mean current source of sample-and-hold circuit was reduced. At this time, also the transistor size of the input stage of the amplifier was multiplied by 1/(1+n) in the same way, and the current densities of transistors were always made equal. Accordingly, when only the current value is changed, the magnitude of gate/source voltage Vgs of the input transistor changes and becomes equivalent to the input common voltage. The amplifier of the source grounded input stage performs the amplification operation of the amount of this change, therefore there is a problem of the shift of the output operation point, but this can be prevented according to the present invention.

(Embodiment 8)

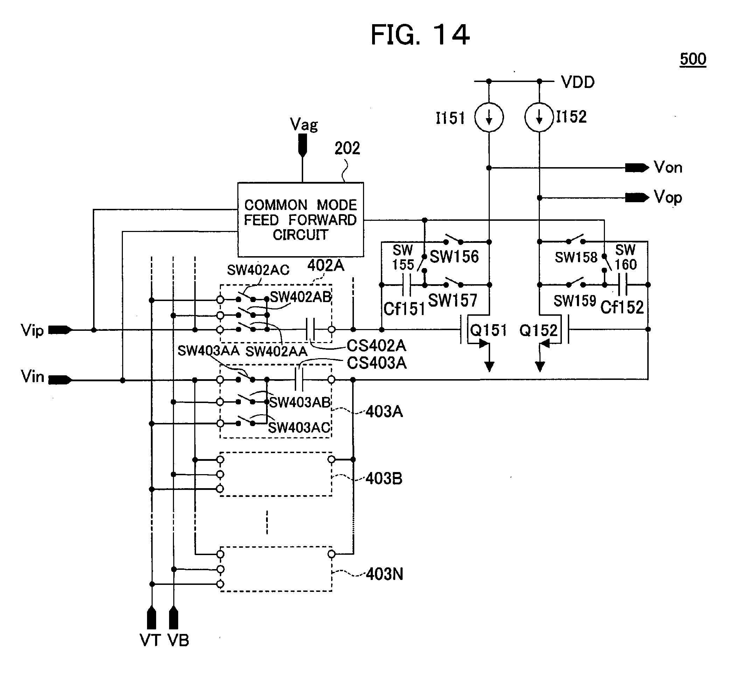

Next, an MDAC 500 of another embodiment is shown in FIG. 14. This MDAC 500 has a configuration obtained by using the S/H circuit 200 of FIG. 7 in the MDAC 400 shown in FIG. 12.

In the circuit configuration of the MDAC 500, a DAC is connected to the S/H circuit 200 shown in FIG. 7, and further DACs are connected to gates of the NMOS transistors Q151 and Q152. Each DAC has the same circuit configuration of DAC shown in FIG. 13, therefore the explanation of the circuit configuration is omitted here, and an explanation will be given of only the circuit operation.

An explanation will be given of the operation of the MDAC 500. Assume now that the input circuits 402A and 403A are selected at the AD converter 411.

When the operational amplifier is in the reset mode, referring to FIG. 6A and FIG. 6B, the CK1 becomes the "H" level, and the CK2 becomes the "L" level. The switches at that time perform the same switch (SW) operation of the MDAC 450 shown in FIG. 13. As a result, the NMOS transistors Q151 and Q152 act as the MOS diodes. Further, VCMMD voltages are supplied from the CMFF circuit 202 to the Cf151 and Cf152 via the SW155 and SW160. The output voltages from the MDAC (500) of the bit blocks in the former stage are supplied as input voltages, for example Vip and Vin to the sample capacitors, and charged with respect to Vgs of the MOS transistors Q151 and Q152.

Next, at the time of the amplification mode, each SW becomes the inverse operation state to that at the time of the reset mode, and as a result, the NMOS transistors Q151 and Q152 become the amplification operation state. Further, switches of the input circuit are operated and connected to either one of VT or VB in response to the control signal from the ADC 411. Signals sampled at the time of the reset via input capacitors and amounts of changes from VT or VB are transmitted to the operational amplifier via each input capacitor. These amounts of changes are multiplied by the gain of the MDAC 500 and supplied to bit blocks in the next stage.

Below, in the same way, the same operation is repeated between bit blocks, and the operation of AD conversion is carried out in synchronization with the clock timing.

(Embodiment 9)

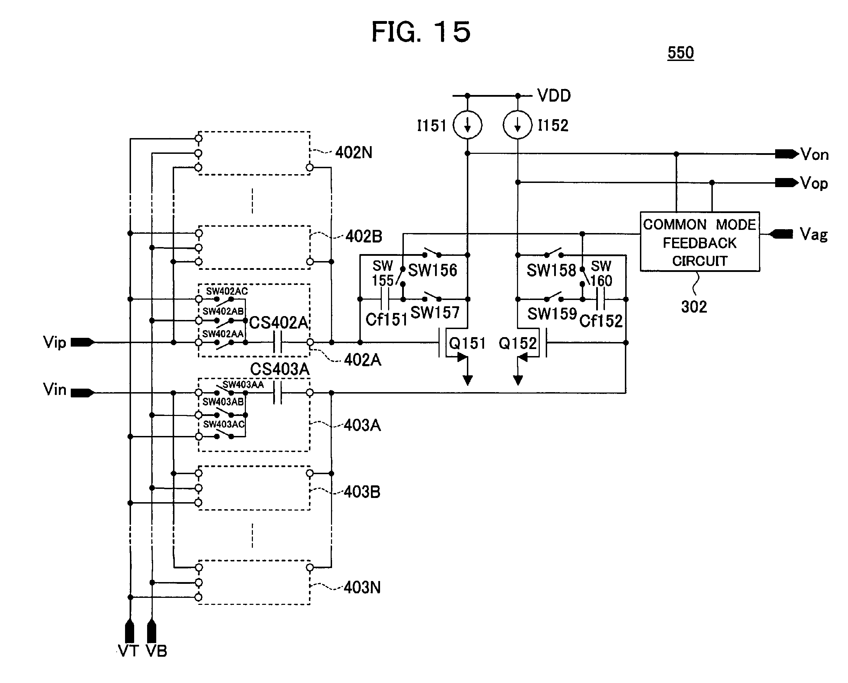

Next, the MDAC 550 of another embodiment is shown in FIG. 15. This MDAC 550 is configured with the S/H circuit 300 of FIG. 10 used in the MDAC 400 shown in FIG. 12.

In the circuit configuration of the MDAC 550, DACs are further connected to gates of the NMOS transistors Q151 and Q152 in the S/H circuit 300 shown in FIG. 10. Each DAC is the same as the DAC circuits shown in FIG. 13, therefore the explanation of the circuit configuration is omitted here, and an explanation will be given only of the circuit operation.

An explanation will be given of the operation of the MDAC 550. Now assume that input circuits 402A and 403A are selected at the AD converter 411.

When the MDAC 550 is at the reset mode, the same SW operation as that of the MDAC 500 shown in FIG. 14 is performed. As a result, the NMOS transistors Q151 and Q152 act as MOS diodes. Further, VCMMD (voltages) are supplied from the CMFB circuit 302 to the Cf151 and Cf152.

This VCMMD voltage is generated from the output voltage at the time of the amplification mode a half period (cycle) before the present period (cycle), the difference between Vag and the output common voltage is detected, the differential voltage is supplied as the VCMMD voltage to each of Cf151 and Cf152, and this VCMMD voltage is charged with respect to Vgs of the NMOS transistors Q151 and Q152.

Output voltages from the MDAC (550) of the previous bit block are supplied as for example Vip and Vin and charged with respect to Vgs of the MOS transistors Q151 and Q152.

Next, when the MDAC 550 is in the amplification mode, each SW becomes the inverse operation state to that at the time of a preset mode. Further, in response to the control signal from the ADC 411, it is connected to either of VT or VB, and signals sampled at the time of reset via input capacitors and amounts of changes relative to VT or VB are transmitted to the operational amplifier. These amounts of changes are multiplied by the gain of the MDAC 550 and output and supplied to the next bit block.

In this example as well, as explained above, for example, by amplifying the amount of fluctuation at the time of the n-th reset and charging the feedback capacitor at the time of the n+1-th reset, the amount of fluctuation is cancelled out at the time of the n+1-th amplification.

Below, in the same way, the same operation is repeated between the bit blocks, and the AD conversion operation is carried out in synchronization with the clock timing.

In the MDAC, the reference voltages VT and VB are supplied to the above input circuits in response to the thermometer code output of the AD converter of the bit block, but also in this case, when the input common voltage and the intermediate voltage between VT and VB do not coincide, the difference thereof becomes the fluctuation of the common voltage, and the amount of that fluctuation is multiplied by the gain of the MDAC and output. For this reason, the output operation point of the operational amplifier fluctuates, and the output dynamic range will be narrowed.

By previously charging the amount of change of the common voltage in the feedback capacitors by the CMFF circuit and the CMFB circuit, the amount of change of the common voltage occurring in the operational amplifier can be cancelled out, and stable operation can be carried out without causing change of the output operation point.

INDUSTRIAL CAPABILITY

The present invention can be used in a sample-and-hold circuit using switched capacitors and a pipeline AD converter using the same and so on.

**Claims**

**1.** A sample-and-hold circuit comprising:

a first switch supplied with a first reference signal and operating ON/OFF by a first control signal;
a second switching means supplied with a first input signal and operating ON/OFF by a second control signal;
a third switch supplied with a second reference signal and operating ON/OFF by said first control signal;
a fourth switch supplied with a second input signal and operating ON/OFF by said second control signal;
a first capacitor to which signals from said first and second switches are alternatively supplied in response to said first and second control signals;
a second capacitor to which signals from said third and fourth switches are alternatively supplied in response to said first and second control signals;
an amplifier having outputs of said first and second capacitors connected to first and second input terminals, amplifying the same, and outputting the same from the first and second output terminals;
a fifth switch and a third capacitor connected between said first input terminal and first output terminal;
a sixth switch and a fourth capacitor connected between said second input terminal and second output terminal;
first and second variable current sources connected between first and second output terminals of said amplifier and a reference power supply; and
an operation setting circuit supplied with said second control signal and fixing an operation state of said amplifier during the second control signal is supplied.

**2.** A sample-and-hold circuit as set forth in claim 1, wherein:

said fifth switch and said third capacitor are connected in series and said sixth switch and said fourth capacitor are connected in series.

3.  A sample-and-hold circuit as set forth in claim 1, wherein:

    said first and second variable current sources have a plurality of current sources for switching current values by using seventh and eighth switching switches.

4.  A sample-and-hold circuit as set forth in claim 1, wherein:

    said amplifier has a first transistor, and a second transistor is connected via a ninth switching switch in parallel to the first transistor.

5.  A sample-and-hold circuit as set forth in claim 4, wherein:

    said first and second transistors are configured by source grounded insulation gate field effect transistors.

6.  A sample-and-hold circuit as set forth in claim 5, wherein:

    said first and second transistors make current densities constant when switching said ninth switching switch.

7.  A sample-and-hold circuit comprising:

    first, second, third, fourth, fifth, and sixth switches controlled by first and second clocks equal in sampling frequency and not overlapping each other and becoming the conductive state at a point of time when said first clock is ON, seventh, eighth, ninth, and 10th switches which become the conductive state when said second clock is ON,
    an operational amplifier, a capacitor for applying a negative feedback to the operational amplifier, and a capacitor for sampling input signals via said third or fourth switch, wherein
    said first and second switches are connected in parallel to said capacitor for applying negative feedback to said operational amplifier, an input and output of said operational amplifier are short-circuited when said first clock is ON, a difference between a potential of a summing node and the input voltage is charged in the sample capacitor,
    a reference voltage for determining the operation point is supplied to said ninth and 10th switches when said second clock is ON,
    a difference between the voltage charged in said sample capacitor and said reference voltage is amplified by a ratio of said sample capacitance and feedback capacitance and output,
    said operational amplifier is configured by 2 sets of source grounded input stages and 2 sets of current sources, switches which become the conductive state by said second clock are inserted in each set, and a bias current value and a gate width size of the input transistor are multiplied by (n+1) [n > 0, integer] in synchronization with said second clock.

8.  A sample-and-hold circuit as set forth in claim 7, wherein:

    in said operational amplifier, switches of the source grounded input stage are inserted in the drain node.

9.  A sample-and-hold circuit comprising:

    a first switch supplied with a first reference signal and operating ON/OFF by a first control signal;
    a second switch supplied with a first input signal and operating ON/OFF by a second control signal;
    a third switch supplied with a second reference signal and operating ON/OFF by said first control signal;
    a fourth switch supplied with a second input signal and operating ON/OFF by said second control signal;
    a first capacitor to which first output signals from said first and second switching means are alternatively supplied in response to said first and second control signals;
    a second capacitor to which second output signals from said third and fourth switching means are alternatively supplied in response to said first and second control signals;
    a first amplifier having outputs of said first and second capacitors connected to first and second input terminals, amplifying the same, and outputting the same from the first and second output terminals;

a fifth switching means and a third capacitor connected between said first input terminal and first output terminal;

a sixth switching means and a fourth capacitor connected between said second input terminal and second output terminal;

a correction circuit to which said first and second input signals and a third reference signal are supplied and which outputs a correction signal for correcting the operation of said first amplifier to said third and fourth capacitors in response to said second control signal; and

an operation setting means supplied with said second control signal and fixing the operation state of said amplifier during the second control signal is supplied.

10. A sample-and-hold circuit as set forth in claim 9, wherein:

said fifth switch and said third capacitor are connected in series and said sixth switch and said fourth capacitor are connected in series.

11. A sample-and-hold circuit as set forth in claim 9, wherein:

the correction signal for correcting the operation of said first amplifier is supplied to a common connection point of the serially connected fifth switch and third capacitor and a common connection point of the serially connected sixth switch and fourth capacitor.

12. A sample-and-hold circuit as set forth in claim 9, wherein:

said correction circuit supplies said correction signal to said third and fourth capacitors via seventh and eighth switch in response to a third control signal.

13. A sample-and-hold circuit as set forth in claim 9, wherein:

the operation setting circuit for fixing the operation state of said first amplifier charges a ninth switch.

14. A sample-and-hold circuit as set forth in claim 13, wherein:

said ninth switch has a 10th switch connected between the first input terminal and said first output terminal of said first amplifier and controlled by said second control signal and an 11th switch connected between the second input terminal and said second output terminal of said amplifier and controlled by said second control signal.

15. A sample-and-hold circuit as set forth in claim 9, wherein:

said amplifier has a source grounded insulation gate field effect transistor.

16. A sample-and-hold circuit as set forth in claim 9, wherein:

said correction circuit has

a fifth capacitor supplied with said first input signal via a 12th switch,

a sixth capacitor supplied with said second input signal via a 13th switch,

a second amplifier to which outputs of said 11th and 12th capacitors are commonly connected and which is connected to the first input terminal,

a 14th switch for controlling ON/OFF the input/output of said second amplifier,

a seventh capacitor and a 15th switch serially connected between the input and output of said second amplifier, and

a 16th switching means in which said first reference signal is supplied to the common connection point of said seventh capacitor and 15th switch in response to the third control signal.

17. A sample-and-hold circuit comprising:

first, second, third, fourth, fifth, and sixth switches controlled by first and second clocks equal in sampling frequency and not overlapping each other and becoming the conductive state when said first clock is ON, seventh, eighth, ninth, and 10th switches which become the conductive state when said second clock is ON,

an operational amplifier having a source grounded amplifier as the input stage, and a capacitor for applying negative feedback to the operational amplifier, and

a sample capacitor for sampling input signals via said third or fourth switch, wherein

said first and second switches are connected in parallel to the capacitor for applying negative feedback to said operational amplifier, an input and output of said operational amplifier are short-circuited when said first clock is ON, a difference between the potential of a summing node and the input voltage is charged in said sample capacitor,

a reference voltage for determining the operation point is supplied to said ninth and 10th switches when said second clock is ON,

a difference between the voltage charged in said sample capacitor and said reference voltage is amplified by the ratio of said sample capacitance and said feedback capacitance and output, and

provision is further made of a feed forward circuit connecting said input signal and the correction voltage in accordance with said reference voltage to said fifth and sixth switches.

**18.** A sample-and-hold circuit comprising:

first, second, third, fourth, fifth, and sixth switches controlled by first and second clocks equal in sampling frequency and not overlapping each other and becoming the conductive state when said first clock is ON,

seventh, eighth, ninth, and 10th switches which become the conductive state when said second clock is ON,

an operational amplifier having a source grounded amplifier as the input stage and a capacitor for applying negative feedback to the operational amplifier, and

a sample capacitor for sampling input signals via said third or fourth switch, wherein

said first and second switches are connected in parallel to the capacitor for applying negative feedback to said operational amplifier, an input and output of said operational amplifier are short-circuited when said first clock is ON, a difference between the potential of a summing node and the input voltage is charged in said sample capacitor,

a reference voltage for determining the operation point is supplied to said ninth and 10th switches when said second clock is ON, a difference between the voltage charged in said sample capacitor and said reference voltage is amplified by the ratio of said sample capacitance and said feedback capacitance and output, and

the output of the circuit for detecting the difference between the common voltage of said input signals and said reference voltage and, at the same time, amplifying the differential voltage by the ratio of said sample capacitance and the feedback capacitance is connected to said fifth and sixth switches, and the polarity of the circuit is inverse to the polarity of said operational amplifier.

**19.** A sample-and-hold circuit as set forth in claim 18, wherein:

the detection and amplification of the difference between the common voltage of said input signals and said reference voltage has a switched capacitor circuit operating with inverse phase to said control clock of said sample-and-hold circuit.

**20.** A sample-and-hold circuit having:

a first switch supplied with a first reference signal and operating ON/OFF by a first control signal;

a second switch supplied with a first input signal and operating ON/OFF by a second control signal;

a third switch supplied with a second reference signal and operating ON/OFF by said first control signal;

a fourth switch supplied with a second input signal and operating ON/OFF by said second control signal;

a first capacitor to which signals from said first and second switching means are alternatively supplied in response to said first and second control signals;

a second capacitor to which signals from said third and fourth switching means are alternatively supplied in response to said first and second control signals;

an amplifier having outputs of said first and second capacitors connected to first and second input terminals, amplifying the same, and outputting the same from the first and second output terminals;

a fifth switch and a third capacitor connected between said first input terminal and first output terminal;

a sixth switch and a fourth capacitor connected between said second input terminal and second output terminal;

a correction circuit to which said first and second input signals and the third reference signal are supplied and which outputs a correction signal for correcting the operation of said amplifier to said third and fourth capacitors in response to said second control signal; and

an operation setting means supplied with said second control signal and fixing the operation state of said amplifier during the second control signal is supplied.

21. A sample-and-hold circuit as set forth in claim 20, wherein:

said fifth switch and said third capacitor are connected in series and said sixth switch and said fourth capacitor are connected in series.

22. A sample-and-hold circuit as set forth in claim 21, wherein:

a correction signal for correcting the operation of said amplifier is supplied to a common connection point of the serially connected fifth switch and third capacitor and a common connection point of the serially connected sixth switch and fourth capacitor.

23. A sample-and-hold circuit as set forth in claim 21, wherein said sample-and-hold circuit further has
a seventh switch supplied with a correction signal from said correction circuit and supplying said correction signal to said third capacitor in response to the third control signal and
an eighth switch supplied with the control signal from said correction circuit for supplying said correction signal to said fourth capacitor in response to said third control signal.

24. A sample-and-hold circuit as set forth in claim 20, wherein:

the operation setting circuit for fixing the operation state of said amplifier charges a ninth switch.

25. A sample-and-hold circuit as set forth in claim 24, wherein:

said ninth switch has a 10th switch connected between the first input terminal and said first output terminal of said amplifier and controlled by said second control signal and an 11th switch connected between the second input terminal and said second output terminal of said amplifier and controlled by said second control signal.

26. A sample-and-hold circuit as set forth in claim 20, wherein:

said amplifier has a source grounded insulation gate field effect transistor.

27. A sample-and-hold circuit configured by first, second, third, fourth, fifth, and sixth switches controlled by first and second clocks equal in sampling frequency and not overlapping each other and becoming the conductive state at a point of time when the first clock is ON, seventh, eighth, ninth, and 10th switches which become the conductive state when said second clock is ON, an operational amplifier having a source grounded amplifier as the input stage, a capacitor for applying negative feedback to the operational amplifier, and a sampling capacitor for sampling input signals via said third or fourth switch, wherein said first and second switches are connected in parallel to said capacitor for applying negative feedback to said operational amplifier, an input and output of said operational amplifier are short-circuited when said first clock is ON, a difference between the potential of the summing node and the input voltage is charged in said sampling capacitor, said ninth and 10th switches are connected to the reference voltage for determining the operation point when said second clock is ON, and a difference between the voltage charged in said sampling capacitor and said reference voltage is amplified by the ratio of said sampling capacitance and said feedback capacitance and output, and
further comprising a feedback circuit connecting an output common of said sample-and-hold circuit and a correction voltage in accordance with said reference voltage to said fifth and sixth switches.

28. A sample-and-hold circuit configured by first, second, third, fourth, fifth, and sixth switches controlled by first and second clocks equal in sampling frequency and not overlapping each other, and becoming the conductive state at a point of time when the first clock is ON, seventh, eighth, ninth, and 10th switches which become the conductive state when said second clock is ON, an operational amplifier having a source grounded amplifier as the input stage, a capacitor for applying negative feedback to the operational amplifier, and a sampling capacitor for sampling input signals via said third or fourth switch, wherein said first and second switches are connected in parallel to said capacitor for applying negative feedback to said operational amplifier, an input and output of said operational amplifier are short-circuited when said first clock is ON, a difference between the potential of the summing node and the input voltage is charged in said sampling capacitor, said ninth and 10th switches are connected to the reference voltage for determining the operation point when said second clock is ON, and a difference between the voltage charged in said sampling capacitor and said reference voltage is amplified by the ratio of said sampling capacitance and said feedback capacitance and output, **characterized in that**
the output of the circuit for detecting the difference between the output common voltage of said sample-and-hold circuit and said reference voltage and outputting the same as the correction signal is connected to said fifth and sixth switches, and the polarity of the circuit is inverse to the polarity of said operational amplifier.

29. A sample-and-hold circuit as set forth in claim 28, wherein:

the detection and amplification of the difference between the common voltage of said input signals and said reference voltage has the switched capacitor circuit operating with the inverse phase to said control clock of said sample-and-hold circuit.

30. A pipeline AD converter cascade connecting a plurality of AD conversion sub blocks each of which has an AD converter for converting an analog signal to a digital code, a DA converter for converting the digital code output by the AD converter to an analog value, and a sample-and-hold circuit for multiplying a difference between the analog signal applied to said AD converter and the analog signal output from said DA converter by $2^{(a-1)}$ [a: resolution of AD converter] and outputting the same, wherein
said sample-and-hold circuit has
first, second, third, fourth, fifth, and sixth switches controlled by first and second clocks equal in sampling frequency and not overlapping each other and becoming a conductive state at a point of time when said first clock is ON,
seventh, eighth, ninth, and 10th switches which become the conductive state when said second clock is ON, an operational amplifier, a capacitor for applying a negative feedback to the operational amplifier, and a capacitor for sampling input signals via said third or fourth switch,
said first and second switches are connected in parallel to said capacitor for applying negative feedback to said operational amplifier, an input and output of said operational amplifier are short-circuited when said first clock is ON, a difference between the potential of the summing node and the input voltage is charged in the sample capacitor, the reference voltage for determining the operation point is supplied to said ninth and 10th switches when said second clock is ON,
a difference between the voltage charged in said sample capacitor and said reference voltage is amplified by the ratio of said sample capacitance and feedback capacitance and output,
said operational amplifier is configured by 2 sets of source grounded input stages and 2 sets of current sources, switches which become the conductive state by said second clock are inserted in each set, and the bias current value and the gate width size of the input transistor are multiplied by (n+1) [n > 0, integer] in synchronization with said second clock.

31. A pipeline AD converter cascade connecting a plurality of AD conversion sub blocks each of which has an AD converter for converting an analog signal to a digital code, a DA converter for converting the digital code output by the AD converter to an analog value, and a sample-and-hold circuit for multiplying a difference between the analog signal applied to the AD converter and the analog signal output from the DA converter by $2^{(a-1)}$ [a: resolution of AD converter] and outputting the same, wherein
said sample-and-hold circuit has
first, second, third, fourth, fifth, and sixth switches controlled by first and second clocks equal in sampling frequency and not overlapping each other and becoming the conductive state when the first clock is ON,
seventh, eighth, ninth, and 10th switches which become the conductive state when said second clock is ON,
an operational amplifier having a source grounded amplifier as the input stage, a capacitor for applying negative feedback to the operational amplifier, and a sample capacitor for sampling input signals via said third or fourth switch,
said first and second switches are connected in parallel to the capacitor for applying negative feedback to said operational amplifier, an input and output of said operational amplifier are short-circuited when said first clock is ON, a difference between the potential of the summing node and the input voltage is charged in said sample capacitor,
the reference voltage for determining the operation point is supplied to said ninth and 10th switches when said second clock is ON, a difference between the voltage charged in the sample capacitor and said reference voltage is amplified by the ratio of said sample capacitance and said feedback capacitance and output,
the output of the circuit for detecting the difference between the common voltage of said input signal and said reference voltage and, at the same time, amplifying the difference voltage by the ratio of said sample capacitance and the feedback capacitance is connected to said fifth and sixth switches, and a polarity of the circuit is inverse to the polarity of said operational amplifier.

32. A pipeline AD converter cascade connecting a plurality of AD conversion sub blocks each of which is configured by an AD converter for converting an analog signal to a digital code, a DA converter for converting the digital code output by the AD converter to an analog value, and a sample-and-hold circuit for multiplying a difference between the analog signal applied to the AD converter and the analog signal output from the DA converter by $2^{(a-1)}$ [a: resolution of AD converter] and outputting the same, wherein

said sample-and-hold circuit is configured by first, second, third, fourth, fifth, and sixth switches controlled by first and second clocks equal in sampling frequency and not overlapping each other and becoming the conductive state at a point of time when the first clock is ON, seventh, eighth, ninth, and 10th switches which become the conductive state when said second clock is ON, an operational amplifier having a source grounded amplifier as the input stage, a capacitor for applying negative feedback to the operational amplifier, and a sample capacitor for sampling input signals via said third or fourth switch, wherein said first and second switches are connected in parallel to the capacitor for applying negative feedback to said operational amplifier, an input and output of said operational amplifier are short-circuited when said first clock is ON, a difference between the potential of the summing node and the input voltage is charged in said sample capacitor, said ninth and 10th switches are connected to the reference voltage for determining the operation point when said second clock is ON, a difference between the voltage charged in the sample capacitor and said reference voltage is amplified by the ratio of said sample capacitance and said feedback capacitance and output,

the output of the circuit for detecting the difference between the common voltage of said input signal and said reference voltage and, at the same time, amplifying the difference voltage by the ratio of said sample capacitance and the feedback capacitance is connected to said fifth and sixth switches, and the polarity of the circuit is inverse to the polarity of said operational amplifier.

# FIG. 1

FIG. 2A  CK1

FIG. 2B  CK2

# FIG. 3

50

Bias3 ■➤ ⊢Q51  Q55

Bias2 ■➤ ⊢Q52  Q56

Bias1 ■➤  Q53  Q57

Vip ■➤

Vin ■➤  Q54  Q58

Q59

VDD

Vop

Von

COMMON MODE FEEDBACK CIRCUIT — 51

FIG. 4

100

FIG. 5

FIG. 6A CK1

Reset    Reset    Reset

FIG. 6B CK2

Amp    Amp    Amp

# FIG. 7

EP 1 801 976 A1

# FIG. 8

250

Vag

SW257 SW256

SW251    CS250

Vin

SW252    CS251    Cf250    SW255

Vip

Vag                    Vo

251

SW253 / SW254

Vag

Vag

FIG. 9A CK1 | Reset | Reset | Reset |

FIG. 9B CK2 | Amp | Amp | Amp |

FIG. 9C CK3 | Reset | Reset | Reset |

FIG. 9D CK4 | Amp | Amp | Amp |

# FIG. 10

EP 1 801 976 A1

# FIG. 11

350

SW351　　CS350

Vin ■

SW352　　CS351

Vip ■

SW353　　SW354

Vag

SW
355

351

Vag

Vo

FIG. 12A

IN S/H 421

ANALOG INPUT
SIGNAL

422A 422B 422C 422D

| n1b 1st | n2b 2nd | n3b 3rd | n4b 4th |

ERROR CORRECTION/CLOCK
GENERATION CIRCUIT 423

FIG. 12B

IN

410 413 414

$-$ $\quad$ S/H $G=2^{(n1-1)}$

DIGITAL DATA

AD DA MDAC

411 412

EP 1 801 976 A1

# FIG. 13

EP 1 801 976 A1

FIG. 14

EP 1 801 976 A1

# FIG. 15

EP 1 801 976 A1

| **INTERNATIONAL SEARCH REPORT** | International application No. |
|---|---|
| | PCT/JP2005/018782 |

**A. CLASSIFICATION OF SUBJECT MATTER**
*H03M1/14* (2006.01), *H03M1/12* (2006.01), *H03F3/70* (2006.01), *H03M1/10* (2006.01), *H03M1/44* (2006.01)

According to International Patent Classification (IPC) or to both national classification and IPC

**B. FIELDS SEARCHED**

Minimum documentation searched (classification system followed by classification symbols)
*H03M1/00* (2006.01)-*1/88* (2006.01), *H03F3/70* (2006.01)

Documentation searched other than minimum documentation to the extent that such documents are included in the fields searched

| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2002-325038 A (Hitachi ULSI Systems Co., Ltd.), 08 November, 2002 (08.11.02), Par. Nos. [0019] to [0037]; Figs. 1 to 5 (Family: none) | 1-32 |
| A | JP 2002-163894 A (Nippon Precision Circuits Inc.), 07 June, 2002 (07.06.02), Column 5, lines 7 to 14; Fig. 5 & US 2002/0135402 A1 & US 6437608 B2 | 1-32 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 25 November, 2005 (25.11.05) | 06 December, 2005 (06.12.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| International application No. |
| --- |
| PCT/JP2005/018782 |

**Box No. II**      **Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III**      **Observations where unity of invention is lacking (Continuation of item 3 of first sheet)**

This International Searching Authority found multiple inventions in this international application, as follows:
Claims describe two inventions: an invention of claims 1-8 and 30 for reducing an average operating current; and an invention of claims 9-29, 31 and 32 for suppressing input common mode fluctuations.

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest.

                               ☐ No protest accompanied the payment of additional search fees.

Form PCT/ISA/210 (continuation of first sheet (2)) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5014199 A

- JP 2000201054 A

**Non-patent literature cited in the description**

- **DAISUKE MIYAZAKI et al.** A 10-b 30-MS/s LOW-POWER Pipelined CMOS A/D Converter Using a Pseudo Differential Architecture. *IEEE JOURNAL OF SOLID-STATE CIRCUIT,* February 2003, vol. 38 (2), 370-373